# EUROPEAN PATENT APPLICATION

(11) **EP 4 632 964 A1**
(43) Date of publication of application: **15.10.2025**
(21) Application number: 23909336.2
(22) Date of filing: 12.09.2023
(51) Int. Cl.: H01R 13/74, H01R 13/631

(54) **COMPUTING DEVICE AND NODE DEVICE**

(30) Priority: 30.12.2022 CN 202211733787
(71) Applicant: xFusion Digital Technologies Co., Ltd., Zhengzhou, Henan 450046 (CN)
(72) Inventor: XIA, Weimin, Zhengzhou, Henan 450046 (CN); CHEN, Gang, Zhengzhou, Henan 450046 (CN); DAN, Yuping, Zhengzhou, Henan 450046 (CN); YANG, Chengjian, Zhengzhou, Henan 450046 (CN)
(74) Representative: MERH-IP Matias Erny Reichl Hoffmann Patentanwälte PartG mbB
(86) International application number: PCT/CN2023/118197
(87) International publication number: WO 2024/139399

(57) **Abstract**

The present application provides a computing device and a node device, the computing device including a mounting member, a connecting member, a floating member, a connector, an electronic module, and a backplane system, where the mounting member is provided with a through slot, the through slot extends through the mounting member along a thickness direction of the mounting member, the connecting member is fixedly connected to the mounting member, the floating member is movably connected to the connecting member and is movable relative to the connecting member, the connector is fixedly connected to the floating member and is movable relative to the mounting member when driven by the floating member, the connector is electrically connected between the electronic module and the backplane system, the backplane system includes a terminal connecting member, the terminal connecting member includes a circuit board and a plurality of first conductive terminals, the plurality of first conductive terminals are mounted at an end portion of the circuit board and spaced apart from each other, each terminal connecting member passes through the through slot and is plugged into the connector, and the plurality of first conductive terminals are electrically connected to the connector. The computing device can absorb a mating gap between the connector and the backplane system, thereby reducing a signal transmission loss between the electronic module and the backplane system.

## Description

This application claims priority to Chinese Patent Application No. 202211733787.3 filed with the China National Intellectual Property Administration on December 30, 2022, entitled "COMPUTING DEVICE AND NODE DEVICE", which is incorporated herein by reference in its entirety.

### TECHNICAL FIELD

The present application relates to the field of electronic device technology, and in particular to a computing device and a node device.

### BACKGROUND

With the emergence of big data, cloud computing, and AI (Artificial intelligence), the computing speed of data centers and servers continues to evolve toward 112G. The high-speed link of a device system requires a design with a lower loss. In related art, when a plurality of electronic modules achieve signal interaction through a backplane system, straight male connectors and curved female connectors are generally used in cooperation. However, mating of the straight male connectors and the curved female connectors may lead to an insertion loss in the high-speed link. The backplane system adopts the gold finger design formed by the conductive terminals to mate with the connector of the electronic module, which may reduce the loss. However, when the backplane system is blind-mated to the electronic module, a Demating risk (that is, a mating gap exists between the gold finger and the connector) may exist between the gold finger of the backplane system and the connector of the electronic module, which easily results in the signal transmission loss between the electronic module and the backplane system.

### SUMMARY

Embodiments of the present application aim to provide a computing device and a node device. A connector and a backplane system in the computing device may achieve a floating connection, so that a mating gap (Demating) when the connector and the backplane system are electrically connected can be absorbed, which is conducive to reducing a signal transmission loss between the electronic module and the backplane system.

Embodiments of the present application provide a computing device, including a connector assembly, a mounting member, an electronic module, and a backplane system; where the connector assembly includes a connecting member, a floating member, and a connector; where the mounting member is provided with a through slot, the through slot extends through the mounting member along a thickness direction of the mounting member, the connecting member is fixedly connected to the mounting member, the floating member is movably connected to the connecting member and is movable relative to the connecting member, the connector is fixedly connected to the floating member and is capable of being driven by the floating member to move relative to the mounting member, the connector is electrically connected between the electronic module and the backplane system, the backplane system includes a terminal connecting member, the terminal connecting member includes a circuit board and a plurality of first conductive terminals, the plurality of first conductive terminals are mounted at an end portion of the circuit board and spaced apart from each other, each terminal connecting member passes through the through slot and is plugged into the connector, and the plurality of first conductive terminals are electrically connected to the connector.

In the computing device provided in the present application, the floating member is disposed so that the connector can be driven by the floating member to move relative to the mounting member to achieve a floating connection between the connector and the backplane system, thereby effectively absorbing a mating gap (Demating) between the connector and the backplane system when the connector and the backplane system are electrically connected. This, in turn, facilitates reducing the signal transmission loss between the electronic module and the backplane system.

In a possible implementation, the computing device further includes an elastic member, the elastic member is mounted on the connecting member and abuts against and is connected between the connecting member and the floating member to achieve a movable connection between the connecting member and the floating member.

In a possible implementation, the computing device further includes a fixing housing, where the fixing housing is mounted on the floating member and sleeved on an outer side of the connector, the fixing housing is provided with a mounting hole, and an opening of the mounting hole faces the mounting member and exposes a connecting end of the connector.

In a possible implementation, a dimension of the mounting hole gradually decreases along a direction facing away from mounting holethe housing toward the connector, which facilitates guiding the backplane system to extend into the notch slot for electrical connection with the connecting end of the connector.

In a possible implementation, there may be a plurality of connecting members. The plurality of connecting members are located on opposite sides of the connector along a direction perpendicular to where the connector is plugged into the terminal connecting member, which may enhance stability of connection between the connector and the mounting member, thereby ensuring balanced force when the floating member moves relative to the mounting member, and further ensuring stability of moving the connector relative to the mounting member and stability of plugging the connector into the terminal connecting member.

In a possible implementation, the floating member includes a carrier part and a mounting part, the mounting part is fixedly connected to the carrier part, the mounting part is provided with a mounting hole, the mounting hole extends through the mounting part along a length direction of the mounting part, the connecting member passes through the mounting hole, the elastic member is mounted in the mounting hole, and the connector is fixedly connected to the carrier part and spaced apart from the mounting part.

In a possible implementation, along a direction from a connector assembly toward themounting member, the mounting hole includes a first hole portion and a second hole portion, the first hole portion is located on a side of the second hole portion facing away from the mounting memberand in communication with the second hole portion, a hole diameter of the first hole portion is greater than a hole diameter of the second hole portion, the connecting member is in clearance fit with the first hole portion and the second hole portion, the connecting member passes through the first hole portion and the second hole portion, and the elastic member is mounted in the first hole portion, and abuts against and is mounted between the connecting member and a bottom wall of the first hole portion.

In a possible implementation, each connecting member includes a blocking portion and an extension portion, the blocking portion is fixedly connected to the extension portion, a circumferential side surface of the blocking portion protrudes relative to a circumferential side surface of the extension portion, the blocking portion is in clearance fit with the first hole portion, and the elastic member is sleeved on the extension portion, and abuts against and is connected between the blocking portion and a bottom wall of the first hole portion.

In a possible implementation, each connecting member further includes a stop portion, the stop portion is fixedly connected to an end of the blocking portion away from the extension portion, and protrudes relative to the mounting part. By disposing the stop portion, an extent to which the floating member moves relative to the connecting member can be limited, so that the extent to which the connector moves relative to the mounting member can be flexibly adjusted based on actual needs, which facilitates achieving a better plug-in effect between the connector and the terminal connecting member.

In a possible implementation, the carrier part is provided with a guide hole, an opening of the guide hole faces the mounting member, the mounting member is provided with a the fixing hole, the fixing hole extends through the mounting member along a thickness direction of the mounting member, and is disposed opposite to the guide hole, the backplane system is provided with a guide member, the guide member is provided on the circuit board and spaced apart from the plurality of first conductive terminals, and the guide member passes through the the fixing hole of the mounting member and fixed in the guide hole. The guide hole and the guide member cooperate to guide the connector to be plugged into the terminal connecting member of the backplane system, thus facilitating an electrical connection between the connector and the backplane system.

In a possible implementation, the connector assembly further includes a stop member, the stop member is mounted in the first hole portion and abuts against between the elastic member and a bottom wall of the first hole portion, the stop member is provided with a through hole, and the through hole extends through the stop member along a thickness direction of the stop member, and the through hole avoids the connecting member. The stop member is disposed to prevent the elastic member from entering the second hole portion while not interfering with the passage of the connecting member, ensuring that the connector can move smoothly relative to the mounting member.

In a possible implementation, the floating member is provided with a first mounting hole and a first mounting slot, the first mounting hole and the first mounting slot extend through the floating member along a thickness direction of the floating member, the first mounting hole is spaced apart from the first mounting slot, and the connector is located in the first mounting slot.In a possible implementation, the connector assembly further includes a fixed base, the fixed base is configured to be fixedly connected to the mounting member and be located between the floating member and the mounting member, the fixed base is provided with a second mounting hole and an avoidance slot, the second mounting hole and the avoidance slot extend through the fixed base along a thickness direction of the fixed base, the second mounting hole is spaced apart from the avoidance slot, the connecting member passes through the first mounting hole and the second mounting hole, the avoidance slot is disposed opposite to the first mounting slot, and the connecting end of the connector is exposed relative to the avoidance slot.

In a possible implementation, the floating member is provided with a second mounting slot, an opening of the second mounting slot is located in a surface of the floating member facing away from the fixed base, and extends through a circumferential side surface of the floating member, the first mounting hole is provided in a bottom wall of the second mounting slot, and extends through the bottom wall of the second mounting slot along a thickness direction of the bottom wall of the second mounting slot.

In a possible implementation, the connector assembly further includes an elastic element and a plurality of carrier parts, the plurality of carrier parts are spaced apart on a side wall of the avoidance slot and extend toward the avoidance slot, the connector is located in the avoidance slot and abuts against the plurality of carrier parts, and the elastic element abuts against and is connected between the connector and the floating member.

In a possible implementation, the floating member is further provided with a plurality of retaining parts, and the plurality of retaining parts are spaced apart on a side wall of the first mounting slot. There are a plurality of elastic elements, and the plurality of elastic elements abut against and are connected between the connector and the plurality of retaining parts.

In a possible implementation, there are a plurality of first mounting holes, and the plurality of first mounting holes are disposed around the first mounting slot, and there are a plurality of second mounting holes, and the plurality of second mounting holes are disposed around the avoidance slot. The plurality of first mounting holes and the plurality of second mounting holes are disposed, which facilitates enhancing stability of connection between the connecting member and the mounting member, thereby enhancing stability of connection between the connector and the mounting member, and further ensuring that the connector and the terminal connecting member can be stably plugged.

In a possible implementation, the connector assembly includes a plurality of guide posts, the plurality of guide posts are mounted on a surface of the fixed base toward the floating member and extend along a direction toward the floating member, the plurality of guide posts are spaced apart and disposed around the avoidance slot, the floating member is provided with a plurality of fixing holes, the plurality of fixing holes extend through the floating member along a thickness direction of the floating member, the plurality of fixing holes are spaced apart and disposed around the first mounting slot, and each of the guide posts passes through one of the fixing holes. The guide posts are disposed so that the first mounting slot and the avoidance slot are disposed relative to each other, which facilitates the first mounting slot of the floating member to be aligned with the avoidance slot of the fixed base. This, in turn, facilitates the connecting end of the connector to be exposed relative to the avoidance slot, and facilitates the connector to move relative to the mounting member in the first mounting slot and the avoidance slot.

In a possible implementation, the circuit board includes a first end portion and a main body portion, the first end portion is electrically connected to an end face of the main body portion and protrudes relative to the main body portion, the first end portion is provided with the plurality of first conductive terminals, the main body portion is provided with a plurality of notches, and openings of the plurality of notches face the first end portion, and are located on opposite sides of the first end portion.

In a possible implementation, the terminal connecting member further includes a plurality of second conductive terminals, and the plurality of second conductive terminals are mounted on the circuit board and spaced apart from the plurality of first conductive terminals, and are electrically connected to the plurality of first conductive terminals. The backplane system further includes a mounting housing and a plurality of cables, the terminal connecting member is mounted on the mounting housing, and each cable is mounted inside the housing and electrically connected between second conductive terminals of two terminal connecting members.

Embodiments of the present application further provide a node device. The node device includes a plurality of electronic components, a connector assembly, and a housing, the plurality of electronic components and the connector assembly are mounted inside the housing, the housing is provided with a through slot, the through slot extends through the housing along a thickness direction of the housing, the connector assembly includes a connecting member, a floating member, and a connector, the connection member is fixedly connected to the housing, the floating member is movably connected to the connecting member and is movable relative to the connecting member, the connector is fixedly connected to the floating member and exposed relative to the through slot, and is movable relative to the housing when driven by the floating member.

### BRIEF DESCRIPTION OF DRAWINGS

In order to more clearly illustrate technical solutions in embodiments of the present application or in related art, the accompanying drawings to be used in the embodiments of the present application or in the background will be described below. Apparently, the drawings in the following description are only some embodiments of the present application, and other drawings may be obtained according to these drawings without creative effort for those skilled in the art.
FIG. 1 is a structural diagram of a cabinet according to a first embodiment of the present application;
FIG. 2 is a cross-sectional structural diagram of an electrical connection structure formed by a plurality of electronic modules and a backplane system in the cabinet shown in FIG. 1;
FIG. 3 is a schematic diagram of a partial assembly structure of an electronic module and a connector assembly in the computing device shown in FIG. 1;
FIG. 4 is a top view structural diagram of the assembly structure in FIG. 3;
FIG. 5 is a structural diagram of a mounting part in the partial structure shown in FIG. 4;
FIG. 6 is a schematic diagram of an assembly structure of a connector, a fixing housing, and a fixing portion in the partial structure shown in FIG. 4;
FIG. 7 is an exploded structural diagram of the assembly structure shown in FIG. 6;
FIG. 8 is a partial enlarged view of an A portion in a partial structure shown in FIG. 4;
FIG. 9 is a cross-sectional structural diagram of assembly of a connecting part and a mounting part in the partial structure shown in FIG. 4;
FIG. 10 is a structural diagram of a stop member in the partial structure shown in FIG. 4;
FIG. 11 is a cross-sectional structural diagram of a backplane system in the cabinet shown in FIG. 1;
FIG. 12 is a stereostructural diagram of the backplane system shown in FIG. 11;
FIG. 13 is a partial enlarged view of the backplane system shown in FIG. 12 at B;
FIG. 14 is a structural diagram of a cable box of the backplane system shown in FIG. 12;
FIG. 15 is a partial structural diagram of a cover body in the cable box shown in FIG. 14 after being assembled with a positioning member and a carrier from another perspective;
FIG. 16 is an exploded structural diagram of a fixing member in the backplane system shown in FIG. 12;
FIG. 17 is a structural diagram of a terminal connecting member in the backplane system shown in FIG. 12;
FIG. 18 is a structural diagram of the terminal connecting member shown in FIG. 17 from another perspective;
FIG. 19 is a schematic diagram of an assembly structure of a terminal connecting member, a cable and a fixing member in the backplane system shown in FIG. 12;
FIG. 20 is a schematic diagram of an assembly structure of the electronic module shown in FIG. 4 and the backplane system shown in FIG. 12;
FIG. 21 is a partial structural diagram of a computing device according to a second embodiment of the present application;
FIG. 22 is a schematic diagram of a partial assembly structure of an electronic module and a connector assembly in the computing device according to a third embodiment of the present application;
FIG. 23 is an exploded structural diagram of the assembly structure shown in FIG. 22;
FIG. 24 is an exploded structural diagram of a partial structure of a connector assembly in the assembly structure shown in FIG. 23;
FIG. 25 is an exploded structural diagram of the connector assembly shown in FIG. 23;
FIG. 26 is a schematic diagram of an assembly structure of the connector assembly shown in FIG. 25;
FIG. 27 is a lateral structural view of a computing device according to a fourth embodiment of the present application; and
FIG. 28 is a cross-sectional structural diagram of an electrical connection structure formed by a plurality of electronic modules and a backplane system in the computing device shown in FIG. 27.

### DESCRIPTION OF EMBODIMENTS

The following clearly and completely describes technical solutions in embodiments of the present application in combination with accompanying drawings of the embodiments of the present application. Apparently, the described embodiments are some but not all of the embodiments of the present application. All other embodiments obtained by those skilled in the art without creative efforts based on the embodiments of the present application fall within the protection scope of the present application.

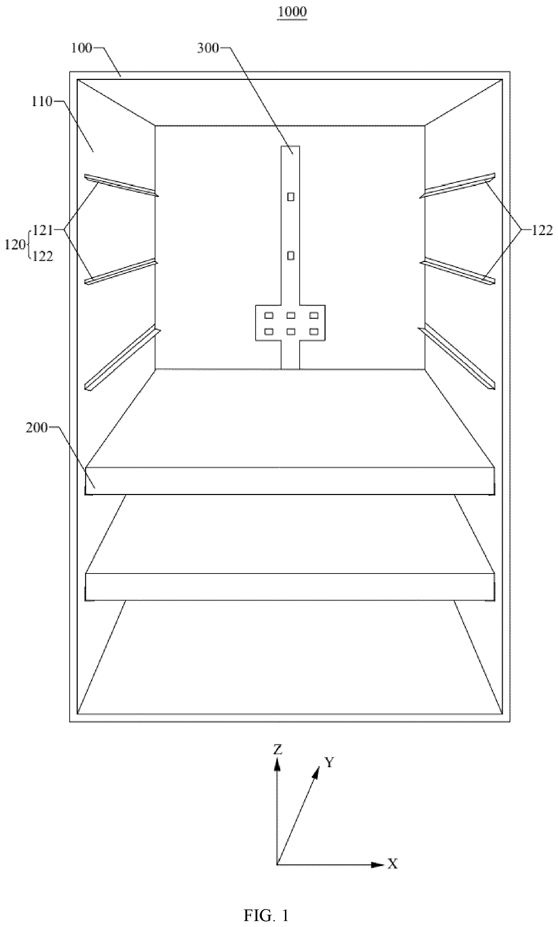

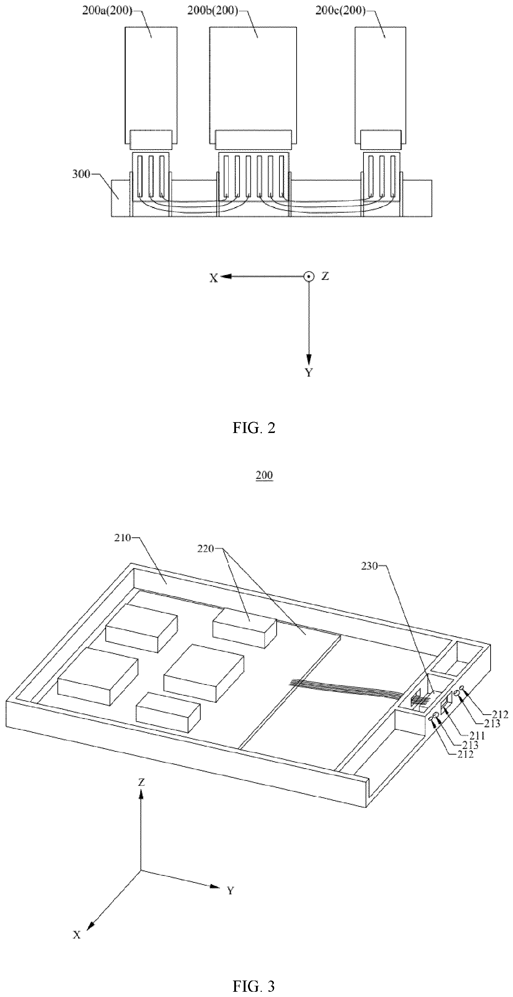

As shown in FIG. 1 and FIG. 2, FIG. 1 is a structural diagram of a computing device 1000 according to a first embodiment of the present application, and FIG. 2 is a cross-sectional structural diagram of an electrical connection structure formed by a plurality of electronic modules 200 and a backplane system 300 in the computing device 1000 shown in FIG. 1. The plurality of electronic modules 200 in FIG. 2 are all in a state before being plugged into the backplane system 300.

For ease of description, a length direction of the computing device 1000 shown in FIG. 1 is defined as an X-axis direction, a width direction as a Y-axis direction, and a height direction as a Z-axis direction, and the X-axis direction, Y-axis direction, and Z-axis direction are mutually perpendicular to each other in pairs. The orientation terms such as "front" and "back" used in the description of the computing device 1000 in the embodiments of the present application, are based on orientations shown in FIG. 1 of the description, where a negative Y-axis direction is defined as the "front" and a positive Y-axis direction as the "back". These terms do not construe a limitation of actual application scenarios of the computing device 1000. The computing device 1000 may be a rack scale server, cabinet switch, and the like. In the embodiments of the present application, the computing device 1000 is described by taking the rack scale server for example.

The computing device 1000 includes a cabinet body 100, a plurality of electronic modules 200, and a backplane system 300. The plurality of electronic modules 200 and the backplane system 300 are mounted inside the cabinet 100. In the embodiment, the plurality of electronic modules 200 are all located on a same side of the backplane system 300, and are electrically connected to the backplane system 300. The backplane system 300 forms a communication channel among the plurality of electronic modules 200, enabling signal interaction among the plurality of electronic modules 200. In the embodiment, the computing device 1000 is a rack scale electronic device, such as a rack scale server. In this case, each electronic module 500 may be a node device, such as a computing node, a switching module, or a management module. It can be understood that in other embodiments, the computing device 1000 may also be a node device. In this case, each electronic module 200 may be an electronic component such as a mainboard, drive, and the like.

Specifically, the cabinet body 100 is provided with a plurality of groups of slots 120. The plurality of groups of slots 120 are spaced apart along the Z-axis direction. Each group of slots 120 includes a first slot 121 and a second slot 122, and the first slot 121 and the second slot 122 extend along the Y-axis direction, and are spaced apart and disposed opposite to each other along the X-axis direction. In the embodiment, the cabinet body 100 includes two side plates 110, the two side plates 110 are spaced apart and disposed opposite to each other along the X-axis direction, and the first slot 121 and the second slot 122 are respectively mounted on the two side plates 110.

Each electronic module 200 is mounted in a group of slots 120, and is mounted into the first slot 121 and the second slot 122 in the group of slots 120. Each electronic module 200 is electrically connected to the backplane system 300, enabling the signal interaction among the plurality of electronic modules 200 through the backplane system 300. Among the plurality of electronic modules 200, some of the electronic modules 200 may be computing nodes 200a, some of the electronic modules 200 may be switching modules 200b, and some of the electronic modules 200 may be management modules 200c. The computing node 200a, switching module 200b, and management module 200c are all electrically connected to the backplane system 300, enabling signal interaction among the computing node 200a, switching module 200b, and management module 200c through the backplane system 300. For example, the computing node 200a may be a computing node module that is equipped with components such as a CPU, memory, drive and the like, and is responsible for a service computing function or achieves other functions. The computing node 200a may be specifically a server service processing subcard or other service processing module subcards. The switching module 200b may achieve data switching among the computing nodes 200a, and its switching protocol may be Ethernet or Infiniband (infinite bandwidth technology). The management module 200c mainly manages each computing node 200a in a server, and management information includes manufacturer information, hardware state information, temperature information, and the like.

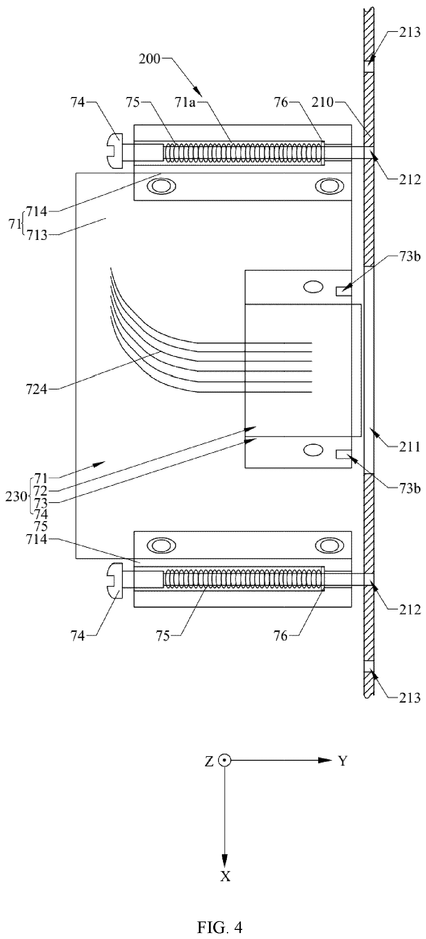

As shown in FIG. 3 and FIG. 4, FIG. 3 is a schematic diagram of a partial assembly structure of an electronic module 200 and a connector assembly 230 in the computing device 1000 shown in FIG. 1, and FIG. 4 is a top view structural diagram of the assembly structure in FIG. 3.

The computing device 1000 further includes a connector assembly 230. The electronic module 200 includes a mounting member 210 and a plurality of electronic components 220. The plurality of electronic components 220 and the connector assembly 230 are all mounted inside the mounting member 210, and some of the plurality of electronic components 220 are electrically connected to the connector assembly 230. For example, the plurality of electronic components 220 include mainboards, drives, storage cards and the like. In the embodiment, the mounting member 210 is a housing of the electronic module 200. In other embodiments, the mounting member 210 may also be other components that may be used for fixing the connector assembly 230.

Specifically, the mounting member 210 is provided with a through slot 211, a plurality of through holes 212, and a plurality of positioning holes 213. The through slot 211, the plurality of through holes 212, and the plurality of positioning holes 213 extend through the mounting member 210 along a thickness direction of the mounting member 210. In the embodiment, the through slot 211, the plurality of through holes 212, and the plurality of positioning holes 213 are all provided in a rear panel of the electronic module 200, so that the electronic module 200 is mounted on the cabinet body 100 from the front of the cabinet body 100 (as shown in FIG. 1), and is electrically connected to the backplane system 300 (as shown in FIG. 1). The plurality of through holes 212 are spaced apart and disposed around the through slot 211. For example, there are two through holes 212, and the two through holes 212 are respectively located on opposite sides of the through slot 211. The plurality of positioning holes 213 are spaced apart and disposed around the through slot 211, and are spaced apart from the through holes 212. For example, there are two positioning holes 213, and the two positioning holes 213 are respectively located on the opposite sides of the through slot 211, and are located between the two through holes 212.

The connector assembly 230 is mounted on a surface of the mounting member 210 toward the negative Y-axis direction, disposed opposite to the through slot 211, and movable relative to the through slot 211. Specifically, the connector assembly 230 includes a floating member 71, a connector 72, a fixing housing 73, a connecting member 74, and an elastic member 75. The connecting member 74 is fixedly connected to an inner side of the mounting member 210, the floating member 71 is movably connected to the connecting member 74, and is movable relative to the connecting member 74. The connector 72 is fixedly connected to the floating member 71, and is movable relative to the through slot 211 of the mounting member 210 along the negative Y-axis direction when driven by the floating member 71. The fixing housing 73 is mounted on the floating member 71 and is sleeved on an outer side of the connector 72. The elastic member 75 is sleeved on the connecting member 74, and abuts against and is connected between the connecting member 74 and the floating member 71. "movably connected" includes directly connected or indirectly connected.

Specifically, the floating member 71 includes a carrier part 713 and a plurality of mounting parts 714. The carrier part 713 is configured to mount the connector 72, thereby achieving a fixed connection between the connector 72 and the floating member 71. In the embodiment, the carrier part 713 is a circuit board, roughly rectangular plate-shaped. A press-fit hole is provided in the circuit board, and extends through the circuit board along a thickness direction of the circuit board, that is, along the Z-axis direction. The plurality of mounting parts 714 are mounted on the carrier part 713 and spaced apart, and are located on opposite sides of the connector 72 along the X-axis direction. In the embodiment, there are two mounting parts 714. The two mounting parts 714 are mounted on an edge of the carrier part 713 by fasteners such as screws, and are located on a same side of the carrier part 713 along the Z-axis direction, are located on opposite sides of the carrier part 713 along the X-axis direction, and are movable relative to the mounting member 210 along the X-axis direction, Y-axis direction, and Z-axis direction.

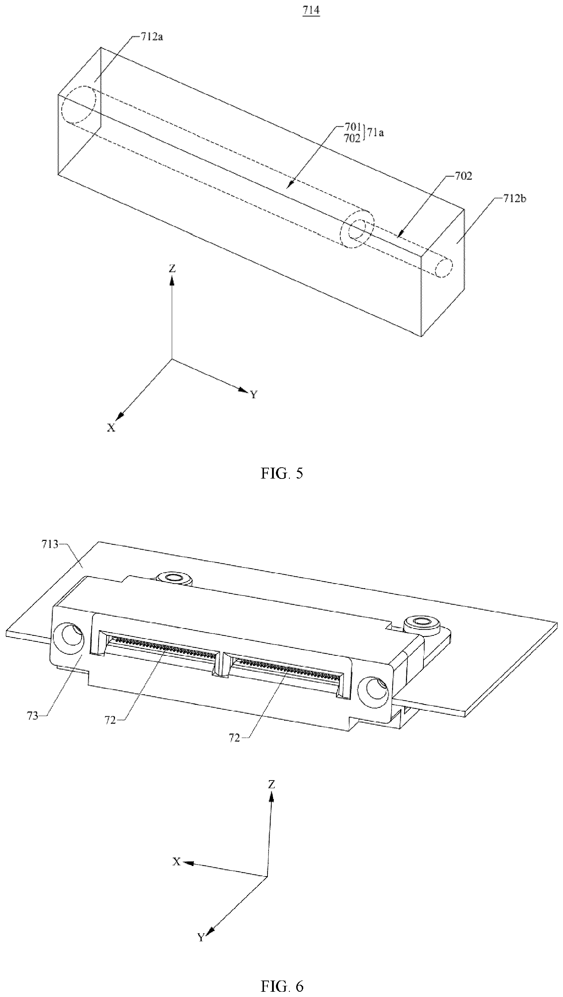

As shown in FIG. 5, FIG. 5 is a structural diagram of the mounting part 714 in the structure shown in FIG. 4.

Each mounting part 714 is provided with a mounting hole 71a. The mounting hole 71a extends through the mounting part 714 along a length direction of the mounting part 714, i.e., along the Y-axis direction, and is used for mounting the connecting member 74. Each mounting part 714 includes a first surface 712a and a second surface 712b that are disposed facing away from each other along the Y-axis direction. The first surface 712a faces away from the mounting member 210, and the second surface 712b faces toward the mounting member 210. The mounting hole 71a includes a first hole portion 701 and a second hole portion 702, where a hole diameter of the first hole portion 701 is greater than a hole diameter of the second hole portion 702. An opening of the first hole portion 701 is located in the first surface 712a of the mounting part 714, and is recessed from the first surface 712a toward the second surface 712b. The second hole portion 702 is in communication with the first hole portion 701, and the second hole portion 702 extends through the second surface 712b of the mounting part 714 and a bottom wall of the first hole portion 701.

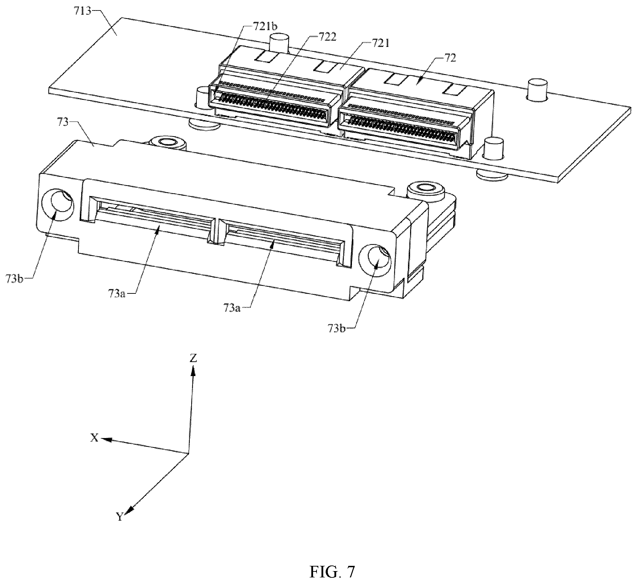

As shown in FIG. 6 and FIG. 7, FIG. 6 is a schematic diagram of an assembly structure of the connector 72, the fixing housing 73, and the carrier part 713 in the partial structure shown in FIG. 4, and FIG. 7 is an exploded structural diagram of the assembly structure shown in FIG. 6. The mounting part 714 is not shown in FIG. 6 and FIG. 7.

There is at least one connector 72. Each connector 72 is fixedly connected to the carrier part 713 to achieve a fixed connection between the connector 72 and the floating member 71. In the embodiment, there are two connectors 72. Each connector 72 includes an outer housing 721, a connecting end 722, and a mating end. The connecting end 722 and the mating end are electrically connected, and are both mounted on the outer housing 721. The connecting end 722 is configured to be electrically connected to the backplane system 300, and the mating end is configured to be electrically connected to an electronic component 220 of the electronic module 200. In the embodiment, the connector 72 is an OSFP (Octal Small Formfactor Pluggable) connector, and the OSFP connector is fixedly connected to the carrier part 713. The connector 72 further includes a fitting end. The fitting end includes a plurality of conductive terminals, and each of the plurality of conductive terminals at the mounting end is press-fitted into a press-fit hole of the carrier part 713.

Specifically, the outer housing 721 is provided with a terminal slot 721b. An opening of the terminal slot 721b is located on a surface of the outer housing 721 toward a positive Y-axis direction. The terminal slot 721b includes a first side wall and a second side wall that are disposed opposite to each other along the Z-axis direction. The connecting end 722 includes two connecting terminal groups, and each connecting terminal group includes a plurality of connecting terminals. The plurality of connecting terminals of the two connecting terminal groups in the connecting end 722 are respectively embedded in the first side wall and the second side wall of the terminal slot 721b, and are spaced apart from each other, and respectively protrude toward the terminal slot 721b relative to the first side wall and the second side wall. The plurality of connecting terminals of the two connecting terminal groups in the connecting end 722 are respectively configured to be electrically connected to the backplane system 300, thereby achieving an electrical connection between the electronic module 200 and the backplane system 300.

The mating end is electrically connected to the electronic component 220 of the electronic module 200 such as a mainboard, to achieve an electrical connection between the connector 72 and a mainboard of the electronic module 200. In the embodiment, the mating end includes a plurality of connecting terminals, and the connector assembly 230 further includes a plurality of cables 724 (as shown in FIG. 4). The plurality of connector terminals of the mating end are respectively electrically connected to the plurality of cables 724, and the plurality of cables 724 are respectively soldered to the mainboard, so as to achieve an electrical connection between the connector 72 and the mainboard of the electronic module 200. For example, the carrier part 713 is a circuit board, and the plurality of connecting terminals of the mating end are electrically connected to the plurality of cables 724 by the carrier part 713. In other embodiments, the connector 72 may also be mounted on the mainboard of the electronic module 200, and the plurality of connecting terminals of the mating end in the connector 72 is press-fitted into a press-fit hole on the mainboard, so as to achieve an electrical connection between the connector 72 and the mainboard of the electronic module 200. Alternatively, in other embodiments, the mating end may also be electrically connected to the mainboard by a flexible printed circuit (Flexible Printed Circuit, FPC) to achieve an electrical connection between the connector 72 and the mainboard.

The fixing housing 73 is sleeved on an outer side of the connector 72, and is fixedly connected to the carrier part 713, achieving a fixed connection between the fixing housing 73 and the floating member 71. The fixing housing 73 is provided with a plurality of mounting holes 73a and a plurality of guide holes 73b. The plurality of mounting holes 73a extend through the fixing housing 73 along the Y-axis direction. In the embodiment, there are two mounting holes 73a. The two mounting holes 73a are spaced apart along the X-axis direction. Each mounting hole 73a is used for mounting one connector 72. Along a direction facing away from the mounting member 210 toward the connector assembly 230, that is, along the negative Y-axis direction, a dimension of each mounting hole 73a gradually decreases, facilitating guiding the backplane system 300 to achieve an electrical connection with the connector 72. In the embodiment, an inner wall of the mounting hole 73a is arranged at an included angle of 45° with an X-Z plane. In other embodiments, an included angle formed by the inner wall of the mounting hole 73a and the X-Z plane may also be other acute angles such as 30° ,60° and the like. Openings of the plurality of guide holes 73b are located on a surface of the fixing housing 73 toward the positive Y-axis direction, and are recessed along the negative Y-axis direction, and are respectively disposed opposite to connecting ends 722 of the plurality of connectors 72, to expose the connecting ends 722 of the connectors 72.

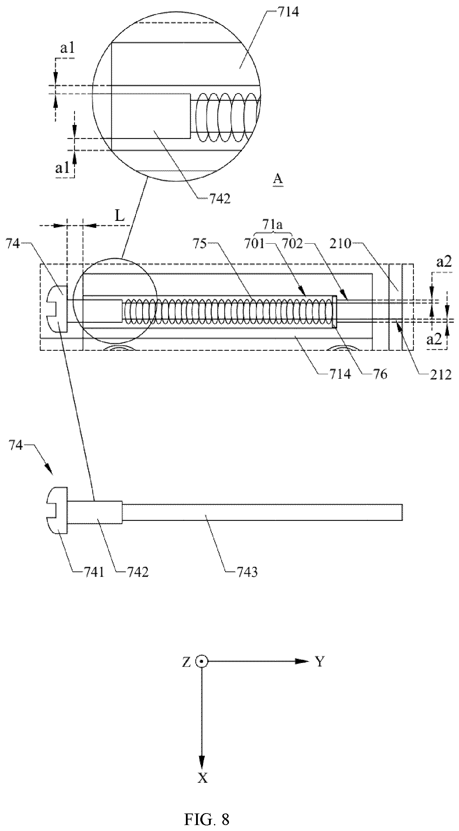

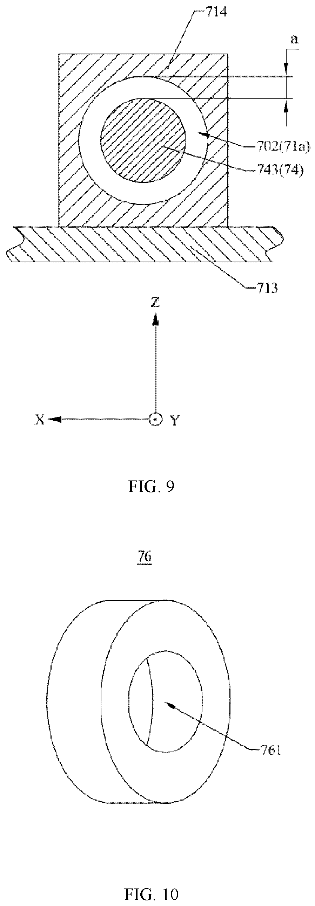

As shown in FIG. 8 and FIG. 9, FIG. 8 is a partial enlarged view of an A portion in a partial structure shown in FIG. 4, and FIG. 9 is a cross-sectional structural diagram of assembly of a connecting member 42 and a mounting part 714 in the partial structure shown in FIG. 4.

The connecting member 74 may pass through the mounting hole 71a of the mounting part 714 and be fixedly connected to the inner side of the mounting member 210. There may be a plurality of connecting members 74. The plurality of connecting members 74 are located on opposite sides of the connector 72 along the X-axis direction, enhancing stability of a fixed connection between the connecting member 74 and the mounting member 210, which is conducive to improving stability of connection between the connector assembly 230 and the mounting member 210, thereby ensuring balanced force when the floating member 71 moves relative to the mounting member 210, and further ensuring stability of the connector 72 moving relative to the mounting member 210. In the embodiment, there are two connecting members 74. The two connecting members 74 are respectively mounted into the mounting holes 71a of the two mounting parts 714. The mounting members 74 are in clearance fit with the mounting holes 71a, allowing the floating member 71 to move relative to the connecting member 74 along the Y-axis direction. In the embodiment, a minimum distance between an outer peripheral surface of the connecting member 74 and a side wall of the mounting hole 71a is a, where a ≥ 0.5 mm (as shown in FIG. 9), so that the mounting part 714 can move smoothly relative to the connecting member 74 without interference between the mounting part 714 and the connecting member 74, thereby achieving floating of the mounting part 714 relative to the mounting member 210 in the X-Z plane.

Specifically, the connecting member 74 includes a stop portion 741, a blocking portion 742, and an extension portion 743. The blocking portion 742 is fixedly connected between the stop portion 741 and the extension portion 743, and a diameter of the stop portion 741 is greater than a diameter of the blocking portion 742, and in turn, the diameter of the blocking portion 742 is greater than a diameter of the extension portion 743. In the embodiment, the stop portion 741 is fixedly connected to an end of the blocking portion 742 away from the extension portion 743. The diameter of the stop portion 741 is greater than a diameter of the mounting hole 71a to limit the extent to which the mounting part 714 is movable relative to the connecting member 74 along the Y-axis direction. In this way, an extent to which the connector 72 is movable relative to the mounting member 210 can be flexibly adjusted according to actual needs. In the embodiment, the stop portion 741 protrudes relative to the mounting part 714, and a distance between the stop portion 741 and an end face of the mounting part 714 toward the stop portion 741 is L, where L ≥ 4.0 mm, so as to limit an extent to which the mounting part 714 is movable relative to the connecting member 74 along the Y-axis direction. The diameter of the blocking portion 742 and the diameter of the extension portion 743 both are less than the diameter of the mounting hole 71a, so as to achieve a clearance fit between the connecting member 74 and the mounting hole 71a. At least a portion of the blocking portion 742 is located in the first hole portion 701 of the mounting hole 71a, and a minimum distance between the outer peripheral surface of the blocking portion 742 and the side wall of the first hole portion 701 is a1, where a1 ≥ 0.5 mm. A portion of the extension portion 743 is located in the second hole portion 702 of the mounting hole 71a, and a minimum distance between the outer peripheral surface of the extension portion 743 and the side wall of the second hole portion 702 is a2, where a2 ≥ 0.5 mm.

Each elastic member 75 is sleeved on one connecting member 74 and abuts against and is connected between the connecting member 74 and the floating member 71 to achieve a movable connection between the floating member 71 and the connecting member 74. Specifically, each elastic member 75 is sleeved on an outer side of the extension portion 743, and abuts against and is connected between the blocking portion 742 and the bottom wall of the first hole portion 701. In the embodiment, the elastic member 75 is a spring. In the embodiment, spring force of the elastic member 75 along the Y-axis direction is greater than three times plugging force between the connector 72 and the backplane system 300. For example, the spring force of the elastic member 75 is 50N-60N.

**In** combination with FIG. 4 and FIG. 10. FIG. 10 is a structural diagram of a stop member 76 in the partial structure shown in FIG. 4.

The connector assembly 230 further includes a plurality of stop members 76, each stop member 76 is mounted in a mounting hole 71a of one mounting part 714 and abuts against between the elastic member 75 and the bottom wall of the first hole portion 701, to prevent the elastic member 75 from entering the second hole portion 702, thereby ensuring that the connector 72 can move smoothly relative to the mounting member 210. Specifically, the stop member 76 is provided with a through hole 761. The through hole 761 extends through the stop member 76 along a thickness direction of the stop member 76. The through hole 761 is configured to avoid the connecting member 74.

After the connector assembly 230 and the mounting member 210 are assembled, the connector 72 is fixedly connected to a side of the carrier part 713 in the floating member 71 toward a positive Z-axis direction. The fixing housing 73 is sleeved on the outer side of the connector 72 and is fixedly connected to the carrier part 713. A notch slot 73c of the fixing housing 73 is disposed opposite to the through slot 211 of the mounting member 210. The connecting end 722 of the connector 72 is exposed relative to the notch slot 73c of the fixing housing 73 and the through slot 211. The connecting member 74 sequentially passes through the first hole portion 701, the through hole 761 of the stop member 76, and the second hole portion 702, and is fixedly connected to an inner wall of the through hole 212 of the mounting member 210, so that the connecting member 74 is fixedly connected to the inner side of the mounting member 210.

Specifically, when the connector assembly 230 and the mounting member 210 are assembled, the connector 72 is first fixedly connected to a side of the carrier part 713 toward a negative Z-axis direction. The plurality of mounting parts 714 are mounted on a side of the carrier part 713 toward the positive Z-axis direction by fasteners such as screws, and are located on both sides of the connector 72 along the X-axis direction. The stop member 76 is mounted into the mounting hole 71a of the mounting part 714, and abuts against the bottom wall of the first hole portion 701. In this case, the through hole 761 of the stop member 76 is disposed relative to the second hole portion 702. The elastic member 75 is sleeved on the outer side of the connecting member 74, and the connecting member 74 and the elastic member 75 are mounted into the mounting hole 71a of the mounting part 714. The stop portion 741 of the connecting member 74 protrudes relative to the mounting part 714 toward the negative Y-axis direction, the extension portion 743 passes through the first hole portion 701, the through hole 761 of the stop member 76 and the second hole portion 702, and is fixed to the inner wall of the through hole 212 of the mounting member 210, so that the connecting member 74 is fixedly connected to the inner side of the mounting member 210. The elastic member 75 is sleeved on the outer side of the extension portion 743, and abuts against and is connected between the blocking portion 742 of the connecting member 74 and the stop member 76. In this case, the guide hole 711a of the carrier part 713 is disposed opposite to the positioning hole 213 of the mounting member 210.

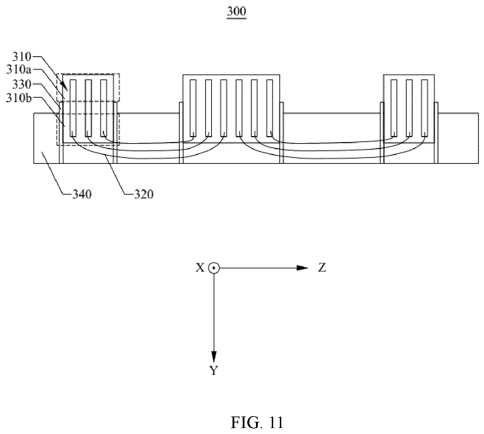

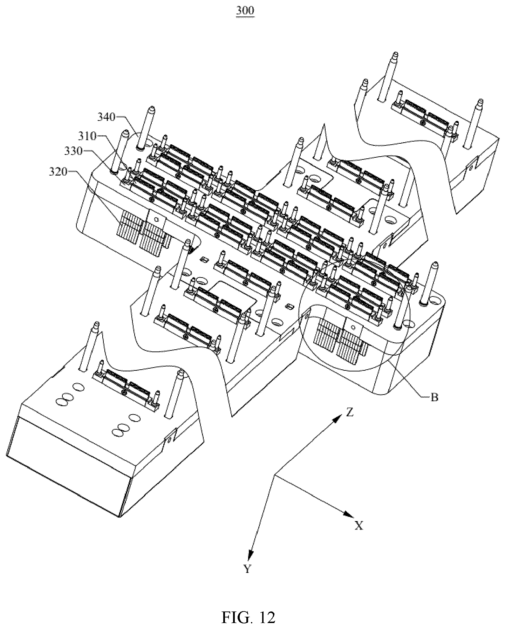

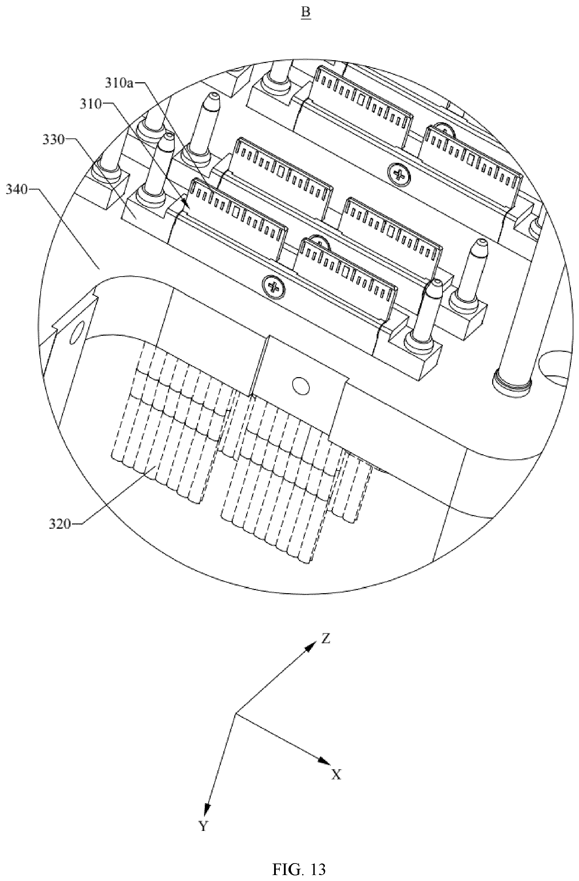

As shown in FIG. 11, FIG. 12 and FIG. 13, FIG. 11 is a cross-sectional structural diagram of the backplane system 300 in the computing device 1000 shown in FIG. 1, FIG. 12 is a stereostructural diagram of the backplane system 300 shown in FIG. 11, and FIG. 13 is a partial enlarged view of the backplane system 300 shown in FIG. 12 at B.

The backplane system 300 includes a cable box 340, a plurality of terminal connecting members 310, a plurality of cables 320, and a plurality of fixing members 330. The plurality of terminal connecting members 310 are all mounted in the cable box 340, and are spaced from each other. The plurality of fixing members 330 are mounted to the cable box 340, and each fixing member 330 mounts at least one terminal connecting member 310 on the cable box 340. Each cable 320 is accommodated inside the cable box 340, and is electrically connected between two terminal connecting members 310.

Specifically, each terminal connecting member 310 includes a connecting end portion 310b and a plug-in end portion 310a. The connecting end portion 310b and the plug-in end portion 310a are disposed facing away from each other, and are electrically connected to each other. The connecting end portion 310b of each terminal connecting member 310 is located inside the cable box 340, and is electrically connected to connecting end portions 310b of other terminal connecting members 310 by the cable 320, thus achieving an electrical connection among the plurality of terminal connecting members 310. The plug-in end portion 310a protrudes relative to the fixing member 330, and is electrically connected to a connector 72 of one electronic module 200. In the embodiment, the plug-in end portion 310a includes a plurality of first conductive terminals. Each of the plurality of first conductive terminals is electrically connected to a corresponding connecting terminal of the connecting end 722 in the connector 72, so that the plug-in end portion 310a is plugged into the connector 72, and is electrically connected to the connector 72, so that the terminal connecting member 310 is electrically connected to the electronic module 200. Thus, the plurality of electronic modules 200 are allowed to be electrically connected to each other by the plurality of terminal connecting members 310, enabling signal interaction among the plurality of electronic modules 200 through the backplane system 300.

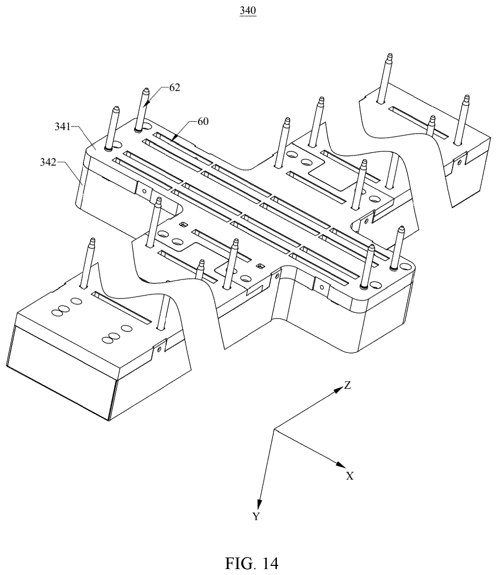

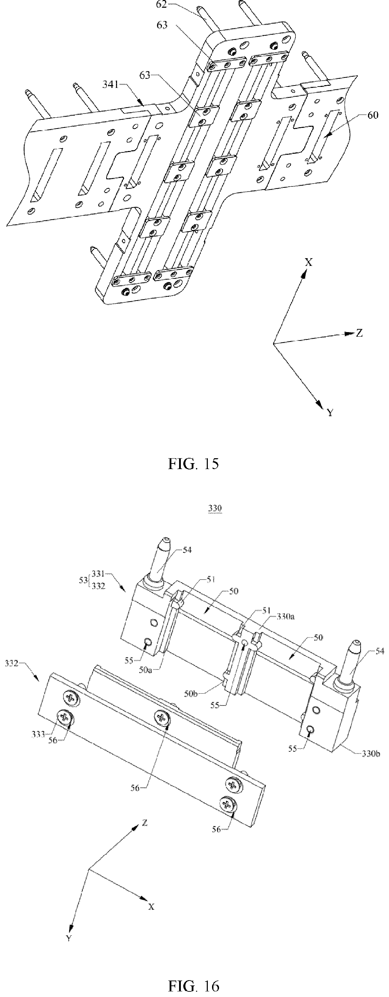

As shown in FIG. 14 and FIG. 15, FIG. 14 is a structural diagram of the cable box 340 of the backplane system 300 shown in FIG. 12, and FIG. 15 is a partial structural diagram of a cover body 341 in the cable box 340 shown in FIG. 14 after being assembled with a positioning member 62 and a carrier 63 from another perspective. Some of the carrying members 63 are omitted in FIG. 14.

The cable box 340 is provided with an accommodating cavity (not shown in FIG. 14) and a plurality of mounting slots 60. The accommodating cavity is configured to accommodate the cable 320. The plurality of mounting slots 60 are spaced apart, and each mounting slot 60 is configured for one fixing member 330 to be mounted therein. An opening of each mounting slot 60 is located on a surface of the cable box 340 toward the negative Y-axis direction, and is in communication with the accommodation cavity.

Specifically, the cable box 340 includes a cover body 341 and a box body 342. The cover body 341 is covered on the box body 342, and encloses the accommodating cavity with the box body 342. A surface of the cover body 341 toward the accommodating cavity is a portion of an inner wall of the accommodating cavity. The cover body 341 is provided with a mounting slot 60, and the mounting slot 60 extends through the cover body 341 along a thickness direction of the cover body 341.

The backplane system 300 further includes a plurality of groups of positioning members 62 and a plurality of groups of carrying members 63. The plurality of groups of positioning members 62 and the plurality of groups of carrying members 63 are mounted in the cable box 340. The plurality of positioning members 62 of each group of positioning members 62 are configured to position one electronic module 200. Specifically, each group of positioning members 62 includes the plurality of positioning members 62, the plurality of positioning members 62 are all mounted on a surface of the cable box 340 facing away from the accommodating cavity, and all extend along a direction facing away from the accommodating cavity (the negative Y-axis direction in FIG. 15), and are disposed around the mounting slot 60. In the embodiment, the plurality of positioning members 62 of each group of positioning members 62 are all mounted on the surface of the cover body 341 facing away from the accommodating cavity, and are all located on both sides of an opening of the mounting slot 60 along the X-axis direction, and are spaced apart from the opening of the mounting slot 60.

The plurality of groups of carrying members 63 are mounted on an inner wall of the accommodating cavity of the cable box 340. Each group of carrying members 63 includes a plurality of carrying members 63, and the plurality of carrying members 63 of each group of carrying members 63 partially block one mounting slot 60. In the embodiment, the plurality of groups of carrying members 63 are all mounted on a surface of the cover body 341 toward the accommodating cavity. The plurality of carrying members 63 of each group of carrying members 63 block two ends of one mounting slot 60 along the X-axis direction.

As shown in FIG. 16, FIG. 16 is an exploded structural diagram of the fixing member 330 in the backplane system 300 shown in FIG. 12. A length direction of the fixing member 330 is defined as an X-axis direction, a width direction as a Y-axis direction, and a height direction as a Z-axis direction.

Each fixing member 330 is provided with at least one fixing slot 50. The fixing slot 50 extends through the fixing member 330 along the Y-axis direction, and is configured for the terminal connecting member 310 to be mounted therein. In the embodiment, one fixing member 330 is provided with two fixing slots 50, and the two fixing slots 50 are spaced apart along the X-axis direction. Each fixing slot 50 is configured for one terminal connecting member 310 to be mounted therein. A plurality of stoppers 51 are provided on a side wall of each fixing slot 50, and each stopper 51 protrudes toward the fixing slot 50 relative to the side wall of the fixing slot 50. The side wall of each fixing slot 50 includes a first side wall 50a and a second side wall 50b that are disposed opposite to each other, and the first side wall 50a and the second side wall 50b extend along the Y-axis direction and are disposed opposite to each other along the X-axis direction. The plurality of stoppers 51 includes a first stopper and a second stopper, the first stopper is provided on the first side wall 50a of each fixing slot 50, and the second stopper is provided on the second side wall 50b of each fixing slot 50. In the embodiment, there are one first stopper and two second stoppers. In other embodiments, there may be two, three, or more first stoppers, and there may be one, three, or more second stoppers. A quantity of the first stoppers and a quantity of the second stoppers are not limited in the embodiments of the present application.

Each fixing member 330 includes a fixing part 53 and a plurality of guide parts 54. The fixing part 53 includes a first surface 330a and a second surface 330b, and the first surface 330a and the second surface 330b are disposed facing away from each other along the Y-axis direction. The fixing part 53 is provided with a fixing slot 50, and the fixing slot 50 extends through the first surface 330a and the second surface 330b. The plurality of guide parts 54 are provided on the first surface 330a of the fixing part 53, and extend along a direction facing away from the first surface 330a, and is disposed around the fixing slot 50. In the embodiment, there are two guide parts 54. The two guide parts 54 are located on both sides of an opening of the fixing slot 50, and are spaced apart from the opening of the fixing slot 50.

In the embodiment, the fixing part 53 includes a first fixing portion 331 and a second fixing portion 332. The first fixing portion 331 and the second fixing portion 332 may be covered along the Z-axis direction and fixedly connected to enclose the fixing slot 50. The first fixing portion 331 includes a first surface and a second surface that are disposed facing away from each other along the Y-axis direction. The first surface of the first fixing portion 331 is a portion of the first surface 330a of the fixing part 53, and the second surface of the first fixing portion 331 is a portion of the second surface 330b of the fixing part 53. Specifically, the fixing slot 50 extends through the first surface and the second surface of the first fixing portion 331 along the Y-axis direction, and extends through a surface of the first fixing portion 331 toward the negative Z-axis direction. The first fixing portion 331 is provided with a stopper 51. The first fixed portion 331 is provided with a plurality of mounting holes 55, openings of the plurality of mounting holes 55 of the first fixing portion 331 are located on a surface of the first fixing portion 331 toward the negative Z-axis direction, and are located on both sides of the fixing slot 50 along the X-axis direction.

The second fixing portion 332 is provided with a plurality of mounting holes 56, and the plurality of mounting holes 56 of the second fixing portion 332 extend through the second fixing portion 332 along a thickness direction of the second fixing portion 332. Fasteners such as screws 333 may sequentially pass through the mounting holes 56 of the second fixing portion 332 and the mounting holes 55 of the first fixing portion 331, and be fixed to inner walls of the mounting holes 55 of the first fixing portion 331, so that the second fixing part 332 is covered on the first fixing portion 331 along the Z-axis direction and is fixedly connected to the first fixing portion 331.

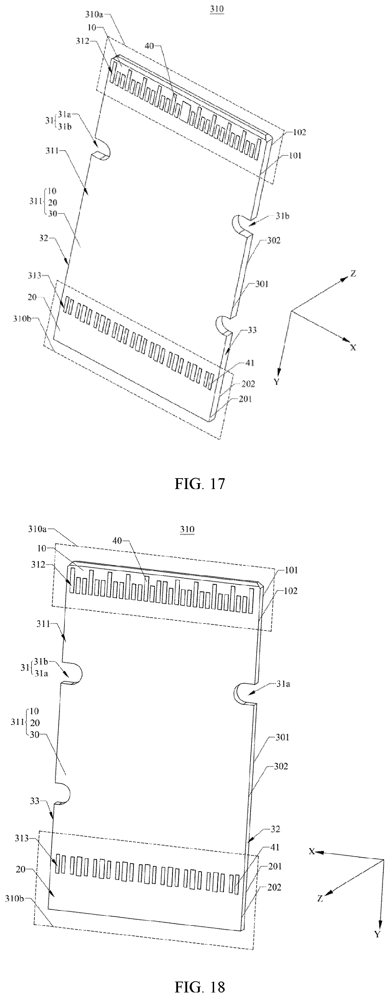

As shown in FIG. 17 and FIG. 18, FIG. 17 is a structural diagram of the terminal connecting member 310 in the backplane system 300 shown in FIG. 12, and FIG. 18 is a structural diagram of the terminal connecting member 310 shown in FIG. 17 from another perspective.

Each terminal connecting member 310 includes a circuit board 311, a first terminal group 312, and a second terminal group 313. The first terminal group 312 and the second terminal group 313 are disposed on a surface of the circuit board 311 and spaced apart, and electrically connected to the circuit board 311 to achieve an electrical connection between the first terminal group 312 and the second terminal group 313. The first terminal group 312 in the terminal connecting member 310 is configured to be electrically connected to the electronic module 200 to achieve an electrical connection between the terminal connecting member 310 and the electronic module 200. The second terminal group 313 in the terminal connecting member 310 is configured to be electrically connected to the second terminal group 313 of other terminal connecting members 310 by a plurality of cables 320 to achieve an electrical connection among the plurality of terminal connecting members 310. In this way, the plurality of electronic modules 200 may be electrically connected to each other by the plurality of terminal connecting members 310, further enabling signal interaction among the plurality of electronic modules 200 through the backplane system 300.

Specifically, the circuit board 311 includes a first end portion 10 (dashed box portion), a second end portion 20 (dashed box portion), and a main body portion 30. The first end portion 10 and the second end portion 20 are spaced apart and disposed opposite to each other along the Y-axis direction, the first end portion 10 is electrically connected to an end face of the main body portion 30 toward the negative Y-axis direction, the second end portion 20 is electrically connected to an end face of the main body portion 30 toward the positive Y-axis direction, and the main body portion 30 is electrically connected between the first end portion 10 and the second end portion 20. In the embodiment, the first end portion 10 and the second end portion 20 each have a uniform thickness, that is, along the Z-axis direction, a thickness of the first end portion 10 is uniform, and a thickness of the second end portion 20 is uniform. The first end portion 10 includes a first mounting face 101 and a second mounting face 102, and the first mounting face 101 and the second mounting face 102 are disposed facing away from each other along a thickness direction of the first end portion 10. The second end portion 20 includes a first fixing face 201 and a second fixing face 202, and the first fixing face 201 and the second fixing face 202 are disposed facing away from each other along a thickness direction of the second end portion 20. The main body portion 30 includes a first surface 301, a second surface 302, a first end face 32, and a second end face 33. The first surface 301 and the second surface 302 are disposed facing away from each other along a thickness direction of the main body portion 30, and the first end face 32 and the second end face 33 are disposed facing away from each other along a width direction of the main body portion 30. The first surface 301 is connected between the first mounting face 101 and the first fixing face 201, and the second surface 302 is connected between the second mounting face 102 and the second fixing face 202.

The main body portion 30 is provided with a snap-fit slot 31. A shape of the snap-fit slot 31 is adapted to a shape of the stopper 51. Each snap-fit slot 31 is configured to snap-fit with a stopper 51 of a fixing member 330, thereby achieving a fixed connection between the main body portion 30 and the fixing member 330, and consequently achieving a fixed connection between the terminal connecting member 310 and the fixing member 330. Specifically, the snap-fit slot 31 extends through the main body portion 30 along the thickness direction of the main body portion 30, and extends through an edge of the main body portion 30. There may be a plurality of snap-fit slots 31. The plurality of snap-fit slots 31 include a first snap-fit slot 31a and a second snap-fit slot 31b. The first snap-fit slot 31a and the second snap-fit slot 31b are respectively provided at opposite ends of the main body portion 30. The main body portion 30 may achieve snap-fit with the fixing member 330 from opposite ends, thereby enhancing connection firmness between the terminal connecting member 310 and the fixing member 330.

Specifically, an opening of the first snap-fit slot 31a is located on a first end face 32 of the main body portion 30. The first snap-fit slot 31a extends through the first end face 32 and is configured to snap-fit with a first stopper of the stopper 51. Specifically, an opening of the second snap-fit slot 31b is located on a second end face 33 of the main body portion 30. The second snap-fit slot 31b extends through the second end face 33 and is configured to snap-fit with a second stopper of the stopper 51. A quantity of the first snap-fit slots 31a may be different from that of the second snap-fit slots 31b, achieving a foolproof effect and ensuring a precise assembly between the terminal connecting member 310 and the fixing member 330. For example, there are one first snap-fit slot 31a and two second snap-fit slots 31b. In other embodiments, the first snap-fit slot 31a and the second snap-fit slot 31b may also have different shapes, achieving the foolproof effect.

The first terminal group 312 includes a plurality of first conductive terminals 40, and the first conductive terminals 40 are mounted on the first end portion 10 and spaced apart from each other. Specifically, the plurality of first conductive terminals 40 include a first face terminal group and a second face terminal group. The plurality of first conductive terminals 40 of the first face terminal group are mounted on a first mounting face 101 of the first end portion 10, and are all electrically connected to the first end portion 10. The plurality of first conductive terminals 40 of the second face terminal group are mounted on a second mounting face 102 of the first end portion 10, and are all electrically connected to the first end portion 10, thereby achieving an electrical connection between the first terminal group 312 and the circuit board 311. In other embodiments, the first terminal group 312 may also only include the first face terminal group, that is, the plurality of first conductive terminals 40 of the first terminal group 312 are all mounted on the first mounting face 101; or, the first terminal group 312 only includes the second face terminal group, that is, the plurality of first conductive terminals 40 of the first terminal group 312 are all mounted on the second mounting face 102. Compared with configuring the first conductive terminals 40 only on the first mounting face 101 or only on the second mounting face 102, the plurality of first conductive terminals 40 are respectively mounted on the first mounting face 101 and the second mounting face 102 in the embodiment, which increases a mounting density of the first conductive terminals 40 and enhances a wiring density of cables 320 connected to the first conductive terminals 40, thereby meeting high cable wiring density requirements of a large and complex computing or communication system.

In the embodiment, the first face terminal group includes a row of first conductive terminals 40, and the row of first conductive terminals 40 includes a plurality of first conductive terminals 40 spaced apart along the X-axis direction. The second terminal group includes a row of first conductive terminals 40, the row of first conductive terminals 40 includes a plurality of first conductive terminals 40, and the plurality of first conductive terminals 40 are spaced apart along the X-axis direction. In other embodiments, a quantity of rows of the first conductive terminals 40 in the first face terminal group may be a plurality, such as two, three and the like, and a quantity of rows of the first conductive terminals 40 in the second face terminal group may also be a plurality, such as two, three and the like, which are not limited in the embodiments of the present application. In addition, the quantity of rows of the first conductive terminals 40 in the first face terminal group may also be different from the quantity of rows of the first conductive terminals 40 in the second face terminal group. For example, the first face terminal group includes one row of the first conductive terminals 40, and the second face terminal group includes two rows of the first conductive terminals 40. In each row of first conductive terminals 40 of the first face terminal group, the plurality of first conductive terminals 40 may be equidistantly spaced apart along the X-axis direction, or may be unequidistantly spaced apart, which are not limited in the embodiments of the present application. In each row of first conductive terminals 40 of the second face terminal group, the plurality of first conductive terminals 40 may be equidistantly spaced apart along the X-axis direction, or may be unequidistantly spaced apart, which are not limited in the embodiments of the present application.

In the embodiment, the plug-in end portion 310a includes a first terminal group 312 and a first end portion 10. The plurality of first conductive terminals 40 in the first terminal group 312 are configured to be electrical connected to the electronic module 200, to achieve an electrical connection between the first terminal group 312 and the electronic module 200, thereby achieving an electrical connection between the plug-in end portion 310a and the electronic module 200.

The second terminal group 313 includes a plurality of second conductive terminals 41, and the plurality of second conductive terminals 41 are mounted on the second end portion 20 and spaced apart from each other. Specifically, the plurality of second conductive terminals 41 include a third face terminal group and a fourth face terminal group. A plurality of second conductive terminals 41 of the second terminal group 313 are mounted on a first mounting face 201 of the second end portion 20, and are all electrically connected to the second end portion 20. A plurality of second conductive terminals 41 of the fourth face terminal group are mounted on a second mounting face 202 of the second end portion 20, and are all electrically connected to the second end portion 20, thereby achieving an electrical connection between the second terminal group 313 and the circuit board 311 and an electrical connection between the second terminal group 313 and the first terminal group 312. In the embodiment, a quantity of rows of the second conductive terminals 41 in the third face terminal group may be same as a quantity of rows of the first conductive terminals 40 in the first face terminal group, and a quantity of rows of the second conductive terminals 41 in the fourth face terminal group may be same as a quantity of rows of the first conductive terminals 40 in the second face terminal group. In other embodiments, the second terminal group 313 may also only include the third face terminal group, that is, the plurality of second conductive terminals 41 of the second terminal group 313 are all mounted on the first mounting face 201; or, the first terminal group 312 only includes the fourth face terminal group, that is, the plurality of second conductive terminals 41 of the second terminal group 313 are all mounted on the second mounting face 202.

In the embodiment, the third face terminal group includes one row of second conductive terminals 41, and the one row of second conductive terminals 41 includes a plurality of second conductive terminals 41, and the plurality of second conductive terminals 41 are spaced apart along the X-axis direction. The fourth face terminal group includes one row of second conductive terminals 41, and the one row of second conductive terminals 41 includes a plurality of second conductive terminals 41, and the plurality of second conductive terminals 41 are spaced apart along the X-axis direction. In other embodiments, a quantity of rows of the second conductive terminals 41 in the third face terminal group may also be different from a quantity of rows of the second conductive terminals 41 in the fourth face terminal group may also be different. For example, the third face terminal group includes one row of second conductive terminals 41, and the fourth face terminal group includes two rows of second conductive terminals 41. In each row of second conductive terminals 41 of the third face terminal group, the plurality of second conductive terminals 41 may be equidistantly spaced apart or unequidistantly spaced apart along the X-axis direction, which are not limited in the embodiments of the present application. In each row of second conductive terminals 41 of the fourth face terminal group, the plurality of second conductive terminals 41 may be equidistantly spaced apart or unequidistantly spaced apart along the X-axis direction, which are not limited in the embodiments of the present application.

In the embodiment, the connecting end portion 310b includes a second terminal group 313 and a second end portion 20. The plurality of second conductive terminals 41 in the second terminal group 313 are configured to be electrically connected to the cable 320, so that the cable 320 is electrically connected among the plurality of second terminal groups 313, and the cable 320 is electrically connected among connecting end portions 310b of the plurality of terminal connecting members 310.

In combination with FIG. 12, in an assembled backplane system 300, a plurality of connecting members 330 are respectively mounted in a plurality of mounting slots 60 of the cable box 340. Each fixing part 53 of each fixing member 330 abuts against a surface of a carrying member 63 toward the mounting slot 60, and protrudes relative to a surface where the opening of the mounting slot 60 is located. The plurality of terminal connecting members 310 are respectively mounted in mounting slots 50 of the plurality of fixing members 330. The plug-in end portion 310a of each terminal connecting member 310 protrudes relative to a first surface 330a of the fixing member 330, and the connecting end portion 310b of each terminal connecting member 310 is accommodated in the accommodating cavity of the cable box 340. The plurality of cables 320 are respectively electrically connected among the connecting end portions 310b of the plurality of terminal connecting members 310, and are accommodated in the accommodation cavity of the cable box 340.

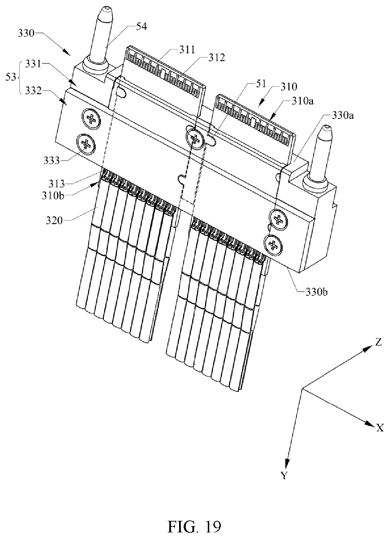

As shown in FIG. 19, FIG. 19 is a schematic diagram of an assembly structure of the terminal connecting member 310, the cable 320 and the fixing member 330 in the backplane system 300 shown in FIG. 12.

When the backplane system 300 is assembled, the terminal connecting member 310, the cable 320, and the fixing member 330 are assembled first. A first snap-fit slot 31a of the circuit board 311 in the terminal connecting member 310 (as shown in FIG. 10) is snap-fitted with a first stopper of the first fixing portion 331, and a second snap-fit slot 31b is snap-fitted with a second stopper to achieve snap-fitting between the snap-fit slot 31 and the stopper 51. The second fixing portion 332 is covered on the first fixing portion 331 along the Z-axis direction to enclose a fixing slot 50, and the first fixing portion 331 and the second fixing portion 332 are fixedly connected by fasteners such as screws 333, and assembled to form a fixing member 330, and the terminal connecting member 310 is mounted into the fixing slot 50 of the fixing member 330.

In this case, the plug-in end portion 310a of the terminal connecting member 310 protrudes relative to a first surface 330a of the fixing part 53, and the connecting end portion 310b protrudes relative to a second surface 330b of the fixing part 53. Meanwhile, the guide part 54 is located on a side of the fixing member 330 toward the plug-in end portion 310a. The snap-fit slot 31 and the stopper 51 are snap-fitted, which prevents the terminal connecting member 310 from falling off along the Y-axis direction. The first fixing portion 331 and the second fixing portion 332 are covered along the Z-axis direction, which prevents the terminal connecting member 310 from falling off along the Z-axis direction. The plurality of cables 320 are respectively electrically connected to the plurality of second conductive terminals 41 of the second terminal group 313 in the connecting end portion 310b, so that the plurality of cables 320 are electrically connected among the connecting end portions 310b of the plurality of terminal connecting members 310.

Then, the assembly structure shown in FIG. 19 and the cable box 340 are assembled. Specifically, the fixing part 53 of the fixing member 330 is mounted into the mounting slot 60 of the cover body 341 in the cable box 340 (see FIG. 14), the connecting end portions 310b of the plurality of terminal connecting members 310 and the plurality of cables 320 are placed inside the box body 342, and the box body 342 is covered on the cover body 341 to form a box body 61 of the cable box 340. The second surface 330b of the fixing part 53 abuts against a surface of the carrying member 63 (see FIG. 15) toward the mounting slot 60, and the first surface 330a of the fixing part 53 protrudes relative to the box body 61 of the cable box 340. The connecting end portions 310b of the plurality of terminal connecting members 310 and the plurality of cables 320 are accommodated in the accommodating cavity of the box body 61 in the cable box 340.

In the backplane system 300 provided in the embodiments of the present application, the cable 320 is configured to be electrically connected among the second conductive terminals 41 of the plurality of terminal connecting members 310, to achieve an electrical connection among the plurality of terminal connecting members 310. Meanwhile, the first conductive terminals 40 of the plurality of terminal connecting members 310 are respectively electrically connected to the plurality of electronic modules 200, to achieve an electrical connection between the backplane system 300 and the plurality of electronic modules 200, thereby enabling signal interaction among the plurality of electronic modules 200 through the backplane system. In the backplane system 300 provided in the embodiments of the present application, the terminal connecting member 310 is electrically connected to the electronic module 200, eliminating the need for a connector mounted on a conventional backplane system, reducing a quantity of connectors used, which is conducive to reducing a signal transmission loss, thereby improving a signal bandwidth interconnected between the electronic modules 200.

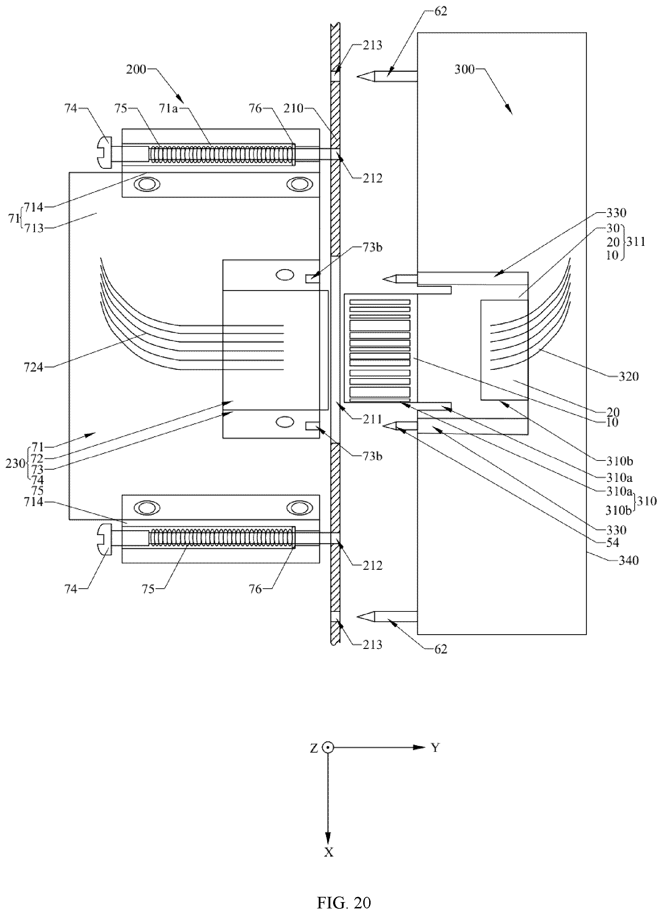

As shown in FIG. 20, FIG. 20 is a schematic diagram of an assembly structure of the electronic module 200 shown in FIG. 4 and the backplane system 300. The backplane system 300 is in an unplugged state with the electronic module 200.

When the electronic module 200 and the backplane system 300 are assembled, a guide hole 711a of the connector assembly 230 in each electronic module 200 and the positioning hole 213 of the mounting member 210 align with each group of positioning members 62 of the backplane system 300. In the embodiment, a fit clearance between the positioning member 62 and the positioning hole 213 of the mounting member 210 is 0.25 mm, and is configured to roughly guide an electrical connection between the backplane system 300 and the connector assembly 230. Specifically, the electronic module 200 is pushed along the positive Y-axis direction, so that each group of positioning members 62 align with and are sequentially inserted into the positioning hole 213 of the mounting member 210 in the electronic module 200 and the guide hole 711a of the connector assembly 230, thereby guiding the through slot 211 of the mounting member 210 to align with the plug-in end portion 310a of the terminal connecting member 310. This facilitates guiding an electrical connection between the connector assembly 230 and the terminal connecting member 310, and in turn, facilitates guiding an electrical connection between the electronic module 200 and the backplane system 300.

In a process of pushing the electronic module 200, the plug-in end portion 310a of the terminal connecting member 310 sequentially passes through the through slot 211 of the mounting member 210, the notch slot 73c of the fixing housing 73 in the connector assembly 230, and is plugged into the terminal slot 721b of the connector 72 to achieve an electrical connection between a plurality of first conductive terminals of the plug-in end portion 310a and a plurality of connecting terminals of the first connecting end of the connector 72 provided in the terminal slot 721b. In this case, the notch slot 73c serves to precisely guide the plug-in end portion 310a of the terminal connecting member 310 to be electrically connected to the connector 72. The terminal connecting member 310 exerts a thrust along the negative Y-axis direction on the connector 72, which may push the connector 72 to move along the negative Y-axis direction, thereby driving the mounting part 714 to move relative to the connecting member 74 along the negative Y-axis direction. The mounting part 714 compresses an elastic member 75 along the negative Y-axis direction, achieving floating of the connector 72 along the Y-axis direction, effectively avoiding over-plugging of the plug-in end portion 310a of the terminal connecting member 310 with the terminal slot 721b of the connector 72, thereby achieving an anti-over-plugging effect. Meanwhile, a mating gap (Demating) between the connector 72 and the plug-in end portion 310a can be absorbed, which is conducive to reducing the signal transmission loss between the electronic module 200 and the backplane system 300. In the embodiment, the connector is designed to float ≥ 4.0 mm along the Y-axis direction, and elastic force of the elastic member 75 is designed to be greater than three times plugging force between the connector 72 and the plug-in end portion 310a, so that a mating gap of greater than or equal to 1 mm between the connector 72 and the plug-in end portion 310a can be absorbed. The mounting hole 71a of the mounting part 714 is in clearance fit with the connecting member 74, so that the mounting part 714 may float relative to the connecting member 74 in the X-Z plane. This ensures that the connector 72 is not restrained when plugged into the plug-in end portion 310a of the terminal connecting member 310.

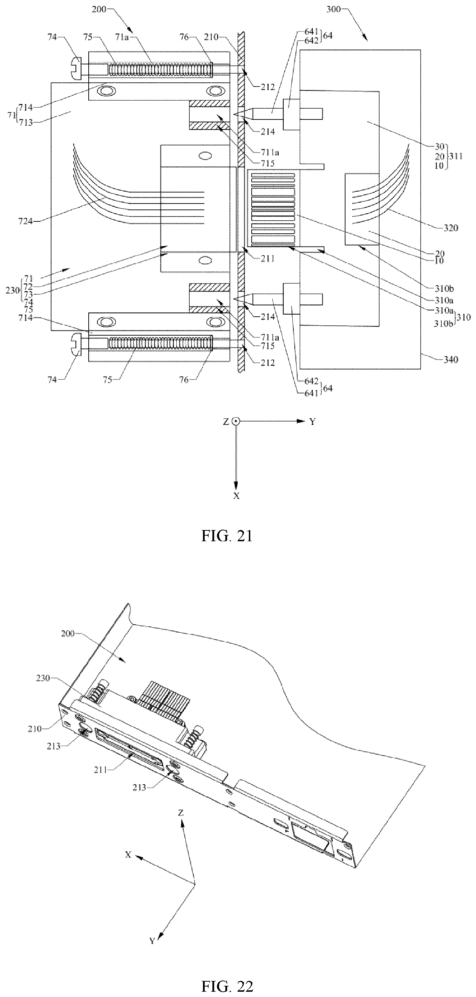

As shown in FIG. 21, FIG. 21 is a partial structural diagram of the computing device 1000 according to a second embodiment of the present application. The electronic module 200 is in an unplugged state with the backplane system 300.

The electronic module 200 in the second embodiment differs from the electronic module 200 in the first embodiment in that the connector assembly 230 in the electronic module 200 is provided with a guide hole 711a, and the backplane system 300 further includes a guide member 64, and the guide member 64 is mounted on the terminal connecting member 310.

Specifically, the mounting member 210 is further provided with a fixing hole 214, and the fixing hole 214 extends through the mounting member 210 along a thickness direction of the mounting member 210. The floating member 71 further includes a plurality of positioning members 715, the plurality of positioning portions 715 are fixedly connected to the carrier part 713 and are located on opposite sides of the connector 72 along the X-axis direction. Each positioning portion 715 is provided with a guide hole 711a having an opening located on a surface of the positioning portion 715 toward the mounting member 210 and arranged opposite to the fixing hole 214 of the mounting member 210. The guide hole 711a is configured to guide the connector 72 of the connector assembly 230 to be electrically connected to the backplane system 300.

The guide member 64 includes a guide part 641 and a protrusion part 642, the guide part 641 is mounted on the circuit board 311 of the terminal connecting member 310, and both extend in a direction facing away from the circuit board 311. The protrusion part 642 is fixedly connected to the guide part 641 and protrudes relative to an outer peripheral surface of the guide part 641. The protrusion part 642 is configured to control a depth at which the plug-in end portion 310a of the terminal connecting member 310 is inserted into the connector 72 of the electronic module 200, thereby preventing the plug-in end portion 310a from being damaged.

When the electronic module 200 is electrically connected to the backplane system 300, the guide member 64 passes through the fixing hole 214 of the mounting member 210 and extends into the guide hole 711a to be fixedly connected to the inner wall of the guide hole 711a, to guide the terminal connecting member 310 of the backplane system 300 to pass through the through slot 211 of the mounting member 211 and be plugged into the connector 72, thereby achieving an electrical connection between the backplane system 300 and the connector 72, and further achieving an electrical connection between the backplane system 300 and the electronic module 200.

In the embodiment, the terminal connecting member 210 is further provided with a notch 34. Specifically, the first end portion 10 protrudes relative to the main body portion 20, the main body portion 30 is provided with a plurality of notches 34, and openings of the plurality of notches 34 all face the first end portion 10, and are located on opposite sides of the first end portion 10. In the embodiment, there are two notches 34, and the two notches 34 are located on opposite sides of the first end portion 10 along the X-axis direction. The notches 34 are disposed so that the circuit board 311 is flexible at the notches 34, which facilitates plug-in between the terminal connecting member 310 and the connector 72, thereby facilitating an electrical connection between the backplane system 300 and the connector assembly 230, and further facilitating an electrical connection between the backplane system 300 and the electronic module 200.

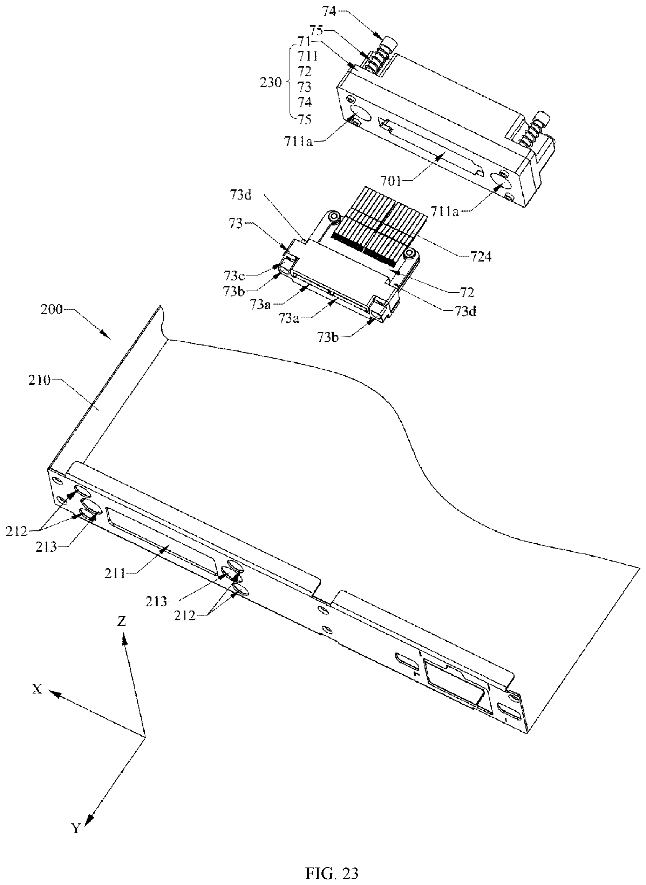

As shown in FIG. 22 and FIG. 23, FIG. 22 is a schematic diagram of a partial assembly structure of the electronic module 200 and the connector component 230 in the computing device 1000 according to a third embodiment of the present application, and FIG. 23 is an exploded structural diagram of the assembly structure shown in FIG. 22.

The computing device 1000 further includes the connector assembly 230, and the electronic module 200 includes a mounting member 210 and a plurality of electronic components (not shown in FIG. 22 and FIG. 23). The plurality of electronic components and the connector assembly 230 are all mounted inside the mounting member 210, and some of the plurality of electronic components are electrically connected to the connector assembly 230. For example, the plurality of electronic components include mainboards, drives, storage cards and the like. In the embodiment, the mounting member 210 is a housing of the electronic module 200. In other embodiments, the mounting member 210 may also be other components that may be used for fixing the connector assembly 230.

Specifically, the mounting member 210 is provided with a through slot 211, a plurality of through holes 212, and a plurality of positioning holes 213. The through slot 211, the plurality of through holes 212, and the plurality of positioning holes 213 extend through the mounting member 210 along the thickness direction of the mounting member 210. In the embodiment, the through slot 211, the plurality of through holes 212, and the plurality of positioning holes 213 are all provided in the rear panel of the electronic module 200, so that the electronic module 200 is mounted on the cabinet body 100 from the front (as shown in FIG. 1), and is electrically connected to the backplane system 300 (as shown in FIG. 1). The plurality of through holes 212 are spaced apart and disposed around the through slot 211. For example, there are four through holes 212. The plurality of positioning holes 213 are spaced apart and disposed around the through slot 211, and are spaced apart from the through holes 212. For example, there are two positioning holes 213. The two positioning holes 213 are respectively located on opposite sides of the through slot 211. The plurality of positioning holes 213 of each electronic module 200 are respectively configured for the plurality of positioning members of the group of positioning members 62 in the cable box 340 to be inserted therein, to guide the through slot 211 of the mounting member 210 to align with the plug-in end portion 310a of the terminal connecting member 310, so that the plug-in end portion 310a of the terminal connecting member 310 extends into the through slot 211 to be plugged into the connector assembly 230.

The connector assembly 230 is mounted inside the mounting member 210, and is disposed opposite to the through slot 211, and is movable relative to the through slot 211. Specifically, the connector assembly 230 includes a floating member 71, a fixed base 711, a connector 72, a plurality of connecting members 74, and a plurality of elastic members 75. The plurality of connecting members 74 are respectively fixedly connected to the inner side of the mounting member 210. The floating member 71 is movably connected to the connecting member 74, and is located inside the mounting member 210. The fixed base 711 is configured to be fixedly connected to the inner side of the mounting member 210, and is mounted between the floating member 71 and the mounting member 210. The connector 72 is mounted inside the floating member 71, and may be exposed relative to the through slot 211, and may be driven by the floating member 71 to move relative to the through slot 211 along the negative Y-axis direction, so that the connector 72 moves relative to the mounting member 210 along a direction facing away from the backplane system 300. For example, the connector 72 is a card connector. Each elastic member 75 is sleeved on an outer side of one connecting member 74, and abuts against and is connected between the connecting member 74 and the floating member 71.

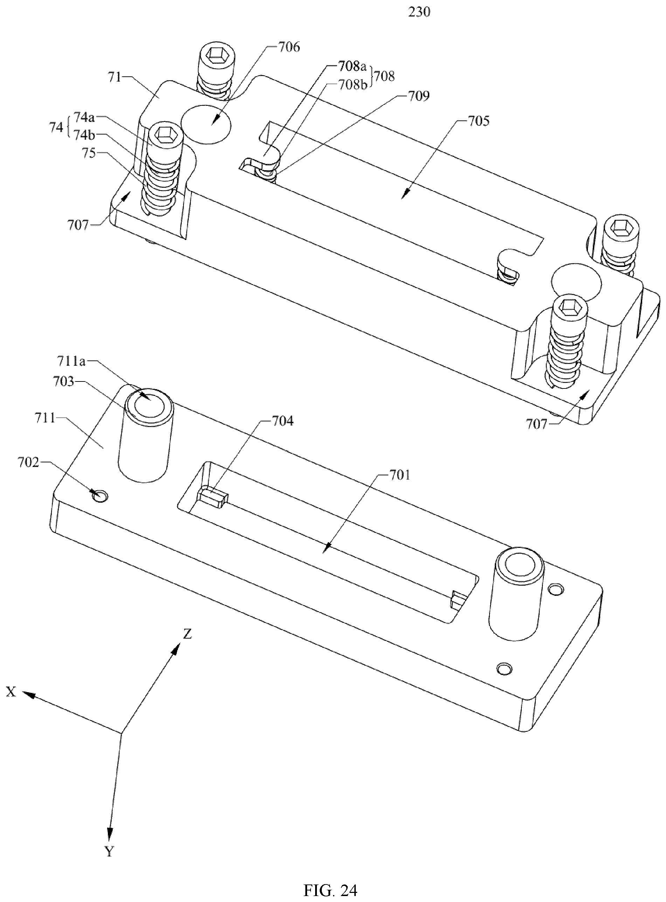

As shown in FIG. 24, FIG. 24 is an exploded structural diagram of a partial structure of the connector assembly 230 in the assembly structure shown in FIG. 23.

The floating member 71 is provided with a first mounting slot 705, a plurality of fixing holes 706, a plurality of second mounting slots 707, and a plurality of first mounting holes, and the first mounting slot 705 and the plurality of fixing holes 706 all extend through the floating member 71 along a thickness direction of the floating member 71. The plurality of fixing holes 706 are spaced apart and disposed around the first mounting slot 705. In the embodiment, the floating member 71 is approximately rectangular. The first mounting slot 705 is a rectangular slot and located in the middle of the floating member 71. There are two fixing holes 706, and the two fixing holes 706 are located on both sides of the first mounting slot 705 along the X-axis direction and are spaced apart from the first mounting slot 705. Openings of the plurality of second mounting slots 707 are located on a surface of the floating member 71 facing away from the fixed base 711, and extend through a circumferential side surface of the floating member 71. The first mounting hole is provided in a bottom wall of the second mounting slot 707, and extends through the bottom wall of the second mounting slot 707 along a thickness direction of the bottom wall of the second mounting slot 707. In the embodiment, there are four second mounting slots 707, and the four second mounting slots 707 are spaced apart, and are located at four corners of the floating member 71. There are four first mounting holes, each provided at a bottom wall of one second mounting slot 707.

The floating member 71 is provided with a plurality of retaining parts 708, and the plurality of retaining parts 708 are spaced apart on a side wall of the first mounting slot 705. In the embodiment, there are two retaining parts 708, and the two retaining parts 708 are disposed on opposite side walls of the first mounting slot 705 along the X-axis direction. Specifically, each retaining part 708 includes a fixing portion 708a and a retaining portion 708b connected to the fixing portion 708a. The fixing portion 708a is fixedly connected to the side wall of the first mounting slot 705 and extends toward the first mounting slot 705. In the embodiment, the fixing portion 708a is flush with a surface of the floating member 71 facing away from the fixed base 711. The retaining portion 708b is protrudingly provided on a surface of the fixing portion 708a toward the fixed base 711, and extends toward the fixed base 711.

The fixed base 711 is provided with an avoidance slot 701 and a plurality of second mounting holes 702. The avoidance slot 701 and the second mounting hole 702 both extend through the fixed base 711 along a thickness direction of the fixed base 711. In the embodiment, the fixed base 711 is generally rectangular, and the avoidance slot 701 is a rectangular slot. The avoidance slot 701 is located in the middle of the fixed base 711. The plurality of second mounting holes 702 are located at an edge of the fixed base 711, arranged around the avoidance slot 701, and spaced apart from the avoidance slot 701. In the embodiment, there are four second mounting slots 702, and the four second mounting slots 702 are respectively located at four corners of the fixed base 711.

Each connecting member 74 is in clearance fit with the first mounting hole in the floating member 71 and extends through the first mounting hole, and is fixedly connected to the fixed base 711. Specifically, each connecting member 74 includes a blocking portion 74a and an extension portion 74b. The blocking portion 74a is fixedly connected to the extension portion 74b, and a circumferential side surface of the blocking portion 74a protrudes relative to a circumferential side surface of the extension portion 74b. The extension portion 74b is in clearance fit with the first mounting hole, allowing the connecting member 74 to move relative to the first mounting hole along the Y-axis direction, thereby enabling the floating member 71 to move relative to the connecting member 74. The extension portion 74b may pass through the first mounting hole, the second mounting hole 702, and the through hole 212 of the mounting member 210, and is fixedly connected to the inner wall of the second mounting hole 702 and the inner wall of the through hole 212 of the mounting member 210, thereby achieving a fixed connection between the connecting member 74 and the mounting member 210 and achieving that the fixed seat 711 is mounted between the floating member 71 and the mounting member 210. For example, the connecting member 74 is a bolt. In the embodiment, there are four connecting members 74. The four connecting members 74 respectively pass through four first mounting holes of the bottom walls of the second mounting slots 707.

Each elastic member 75 is in a compressed state, and abuts against between one connecting member 74 and the floating member 71. Specifically, each elastic member 75 is sleeved on an outer side of the extension portion 74b, and abuts against between the blocking portion 74a and the bottom wall of the second mounting slot 707, so that the elastic member 75 abuts against and is connected between one connecting member 74 and the floating member 71, thereby achieving a movable connection between the floating member 71 and the connecting member 74. The floating member 71, under a thrust along the negative Y-axis direction, may compress the elastic member 75, reducing a spacing between the bottom wall of the second mounting slot 707 and the blocking portion 74a. The connecting member 74 is movable relative to the first mounting hole along the positive Y-axis direction, and the floating member 71 is movable relative to the fixed base 711 along the negative Y-axis direction, which increases deformation space of the elastic element 709, thus further enhancing an extent to which the connector 72 moves along the negative Y-axis direction. For example, the elastic member 75 is a spring. In the embodiment, there are four elastic members 75, and each of the four elastic members 75 is sleeved on an outer side of each of the four connecting members 74.

The connector assembly 230 further includes a plurality of guide posts 703, a plurality of carrier parts 704, and an elastic element 709. Specifically, the plurality of guide posts 703 are all mounted on a surface of the fixed base 711 toward the floating member 71, and all extend along a direction toward the floating member 71. The plurality of guide posts 703 are spaced apart and disposed around the avoidance slot 701. Each guide post 703 is in clearance fit with one fixing hole 706, and is movable relative to the fixing hole 706 along the Y-axis direction. For example, there are two guide posts 703, and the two guide posts 703 are spaced apart, and are located on both sides of the avoidance slot 701 along the X-axis direction.

The plurality of carrier parts 704 are spaced apart on the side wall of the avoidance slot 701, and all extend toward the avoidance slot 701. Each of the plurality of carrier parts 704 is configured to carry the connector 72. There is a height difference between a surface of the carrier part 704 toward the floating member 71 and the surface of the fixed base 711 toward the floating member 71. When the connector 72 is carried by the carrier part 704, the connector 72 is located in the avoidance slot 701, and the side wall of the avoidance slot 701 may prevent the connector 72 from shaking significantly in the avoidance slot 701, thereby enhancing stability of the connector 72 moving along the Y-axis direction. In the embodiment, there are four carrier parts 704, and the four carrier parts 704 are provided on side walls at four corners of the avoidance slot 701. The elastic element 709 is fixedly connected to the retaining portion 708 of the floating member 71, and is configured to be connected to the connector 72. The elastic element 709 may be compressed to drive the connector 72 to move along the negative Y-axis direction, and may exert a thrust along the negative Y-axis direction on the floating member 71. Specifically, the elastic element 709 is sleeved on the retaining portion 708b of the retaining part 708 and abuts against the fixing portion 708a, achieving a fixed connection between the elastic element 709 and the retaining part 708, thereby achieving a fixed connection between the elastic element 709 and the floating member 71. In the embodiment, the elastic element 709 is a spring. There are two elastic members 709. Each of the two elastic members 709 is sleeved on a retaining portion 708b of each of the two retaining portions 708, and abuts against a fixing portion 708a of each of the two retaining portions 708.

The connector assembly 230 is further provided with a plurality of guide holes 711a. Openings of the plurality of guide holes 711a (in combination with FIG. 22) are all toward the mounting member 210, and each guide hole 711a is configured for one positioning member in a group of positioning members 62 of the cable box 340 to be inserted therein, guiding the connector 72 of the connector assembly 230 to be electrically connected to the backplane system 300. In the embodiment, the opening of the guide hole 711a is arranged on the surface of the fixed base 711 toward the mounting member 210, and extends through the fixed base 711 and the guide post 703 along the Y-axis direction, increasing an insertion depth of the positioning member 62, thereby facilitating enhancing assembly stability of the positioning member 62 and the guide hole 711a. In other embodiments, the guide hole 711a may also only extend through the fixed base 711, or not completely extend through the fixed base 711.

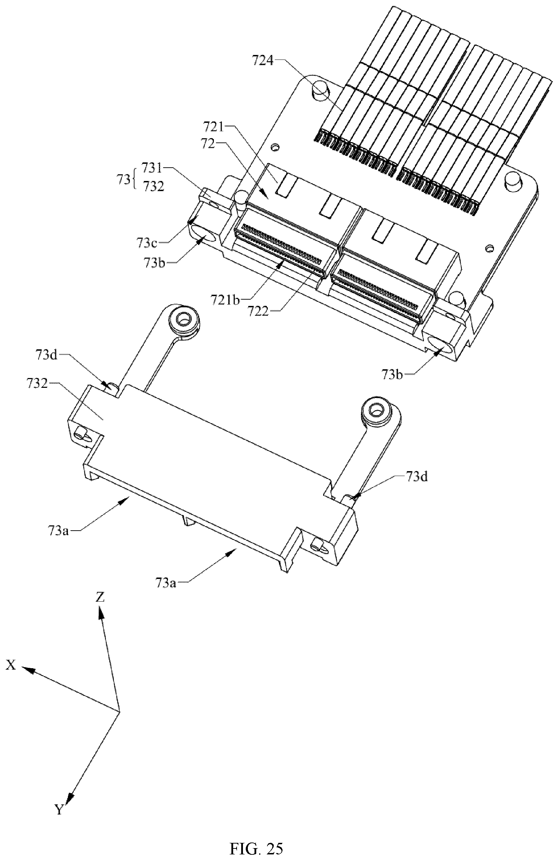

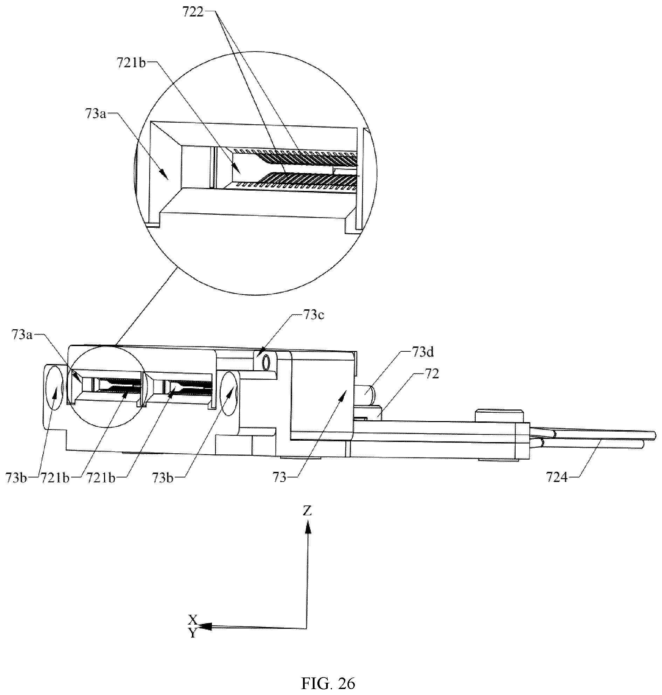

In combination with FIG. 23, FIG. 25 and FIG. 26, FIG. 25 is an exploded structural diagram of the connector assembly 230 shown in FIG. 23, and FIG. 26 is a schematic diagram of an assembly structure of the connector assembly 230 shown in FIG. 25.

The connector 72 includes an outer housing 721, a connecting end 722, and a mating end. The connecting end 722 and the mating end are electrically connected, and both are mounted on the outer housing 721. The connecting end 722 is configured to be electrically connected to the plug-in end portion 310a of the terminal connecting member 310 in the backplane system 300, and the mating end is configured to be electrically connected to an electronic component in the electronic module 200.

Specifically, the outer housing 721 is provided with a terminal slot 721b. An opening of the terminal slot 721b is located on a surface of the outer housing 721 toward the positive Y-axis direction. The terminal slot 721b includes a first side wall and a second side wall that are disposed opposite to each other along the Z-axis direction. The connecting end 722 includes two connecting terminal groups, and each connecting terminal group includes a plurality of connecting terminals. The plurality of connecting terminals of the two connecting terminal groups of the connecting end 722 are respectively embedded in the first side wall and the second side wall of the terminal slot 721b, and are spaced apart from each other, and respectively protrude toward the terminal slot 721b relative to the first side wall and the second side wall. The plurality of connecting terminals of the two connecting terminal groups of the connecting end 722 are respectively configured to be electrically connected to a plurality of first conductive terminals 40 of the first face terminal group and the second face terminal group in the first terminal group 312, to achieve the electrical connection between the connector 72 and the terminal connecting member 310, thereby achieving an electrical connection between the electronic module 200 and the backplane system 300.

The mating end is electrically connected to an electronic component of the electronic module 200 such as a mainboard, to achieve an electrical connection between the connector 72 and the mainboard of the electronic module 200. In the embodiment, the mating end includes a plurality of connecting terminals, and the connector assembly 230 further includes a plurality of cables 724. The plurality of connecting terminals of the mating end are respectively electrically connected to the plurality of cables 724, and are respectively soldered to the mainboard by the plurality of cables 724, to achieve an electrical connection between the connector 72 and the mainboard of the electronic module 200. For example, the plurality of connecting terminals of the mating end are electrically connected to the plurality of cables by a circuit board. In other embodiments, the plurality of connecting terminals of the mating end may also be press-fitted into a press-fit hole on the mainboard to achieve an electrical connection between the connector 72 and the mainboard; alternatively, the mating end may also be electrically connected to the mainboard by a flexible printed circuit (Flexible Printed Circuit, FPC) to achieve an electrical connection between the connector 72 and the mainboard.

The connector assembly 230 further includes a fixing housing 73. The fixing housing 73 is mounted inside the floating member 71 and is sleeved on the outer side of the connector 72, so that the connector 72 is mounted inside the floating member 71. Specifically, the fixing housing 73 includes a first outer surface and a second outer surface that are disposed facing away from each other along a Y-axis direction. The first outer surface faces the positive Y-axis direction, and the second outer surface faces the negative Y-axis direction. In the embodiment, the first outer surface is approximately rectangular. The fixing housing 73 is provided with a plurality of mounting holes 73a, a plurality of guide holes 73b and a plurality of notch slots 73c. The plurality of mounting holes 73a extend through the first outer surface and the second outer surface of the fixing housing 73 along the Y-axis direction. In the embodiment, there are two mounting holes 73a. The two mounting holes 73a are spaced apart along the X-axis direction. Each mounting hole 73a is used for one connector 72 fixed therein. Along a direction facing away from the mounting member 210 toward the connector assembly 230, that is, along the negative Y-axis direction, a dimension of each mounting hole 73a gradually decreases, facilitating guiding the backplane system 300 to be electrically connected to the connector 72. In the embodiment, the inner wall of the mounting hole 73a is arranged at an included angle of 45° with an X-Z plane. In other embodiments, an included angle formed by the inner wall of the mounting hole 73a and the X-Z plane may also be other acute angles such as 30° , 60° and the like. Openings of the plurality of guide holes 73b are all located on the first outer surface of the fixing housing 73, and are all recessed from the first outer surface toward the second outer surface. In the embodiment, there are two guide holes 73b, and the two guide holes 73b are spaced apart, and are located on both sides of the two mounting holes 73a along the X-axis direction. Openings of the plurality of notch slots 73c are all located on the first outer surface of the fixing housing 73, and are spaced apart from openings of the mounting holes 73a and openings of the guide holes 73b. The notch slots 73c are recessed from the first outer surface toward the second outer surface, and extend through a circumferential side surface of the fixing housing 73. In the embodiment, there are four notch slots 73c, and openings of the four notched slots 73c are located at four corners of the first outer surface. The fixed housing 73 is further provided with a protrusion part 73d, and the protrusion part 73d is provided on the second outer surface of the fixing housing 73 and extends along the negative Y-axis direction. In the embodiment, there are two protrusion parts 73d, and the two protrusion parts 73d are located on both sides of the second outer surface along the X-axis direction.

In the embodiment, the fixing housing 73 includes a first housing portion 731 and a second housing portion 732. The second housing portion 732 is covered on the first housing portion 731, and enclose a plurality of mounting holes 73a with the first housing portion 731. The first housing portion 731 is provided with a plurality of guide holes 73b and a plurality of notch slots 73c. The openings of the plurality of guide holes 73b are all located on the surface of the first housing portion 731 toward the positive Y-axis direction, and are recessed along the negative Y-axis direction. The openings of the plurality of notch slots 73c are all located on the surface of the first housing portion 731 toward the positive Y-axis direction, and are recessed along the negative Y-axis direction, and extend through a circumferential side surface of the first housing portion 731. The second housing portion 732 is provided with a protrusion part 73d, the protrusion part 73d is disposed on a surface of the second housing portion 732 facing away from the first housing portion 731, and extends along a direction facing away from the first housing portion 731.

In an assembled electronic module 200, the fixed base 711 is mounted inside the mounting member 210, and the avoidance slot 701 is arranged opposite to the through slot 211. The floating member 71 is mounted on a side of the fixed base 711 facing away from the mounting member 210, and the first mounting slot 705 is arranged opposite to the avoidance slot 701 and the through slot 211. Each guide post 703 passes through one fixing hole 706. The connector 72 is mounted into the mounting hole 73a of the fixing housing 73, and the connecting end 722 of the connector 72 located inside the mounting hole 73a. The bottom walls of the plurality of notch slots 73c of the fixing housing 73 respectively abut against the plurality of carrier parts 704, so that the fixing housing 73 abuts against the carrier parts 704, and the mounting hole 73a is disposed opposite to the avoidance slot 701, so that the connector 72 passes through the avoidance slot 701 and the first mounting slot 705, and further the connector 72 is mounted inside the floating member 71 and exposed relative to the through slot 211. One end of the elastic element 709 is sleeved on the protrusion part 73d of the fixing housing 73 and abuts against the second outer surface of the fixing housing 73, achieving a fixed connection between the elastic element 709 and the fixing housing 73, thereby achieving a fixed connection between the elastic element 709 and the connector 72. The other end of the elastic element 709 is sleeved on the retaining portion 708b of the retaining part 708 and abuts against the fixing portion 708a of the retaining part 708, so that the elastic element 709 is connected between the floating member 71 and the fixing housing 73, thereby achieving that the elastic member 709 is connected between the floating member 71 and the connector 72. The first outer surface of the fixing housing 73 is recessed relative to the surface of the fixed base 711 facing away from the guide post 703, so that the opening of the terminal slot 721b and the opening of the guide hole 73b are both located in the avoidance slot 701. This allows the connector 72 to be located inside the mounting member 210, which prevents the connector 72 from protruding relative to the mounting member 210, thereby enhancing appearance regularity of the electronic module 200. The plurality of connecting members 74 respectively pass through the first mounting hole located in the bottom wall of the second mounting slot 707 and the second mounting hole 702 of the fixed base 711, and are fixedly connected to the inner wall of the second mounting hole 702, thus achieving a fixed connection between the plurality of connecting members 74 and the fixed base 711. Each elastic member 75 abuts against and is connected between the connecting member 74 and the floating member 71. The floating member 71 is movable relative to the fixed base 711 and the connecting member 74 along the negative Y-axis direction, thereby compressing the elastic member 75.

Specifically, when the electronic module 200 is assembled, the connector 72 is mounted into the mounting hole 73a of the fixing housing 73, and the bottom walls of the plurality of notch slots 73c of the fixing housing 73 abut against the surface of the carrier part 704 of the fixed base 711 toward the floating member 71. The two guide posts 703 respectively extend into inner sides of two fixing holes 706, to guide the floating member 71 to be mounted on a side of the fixed base 711 facing away from the mounting member 210, and to guide the avoidance slot 701 of the fixed base 711 to align with the first mounting slot 705 of the floating member 71 and disposed opposite to the first mounting slot 705. When the guide post 703 extends into the fixing hole 706, one end of the elastic element 709 is sleeved on the outer side of the protrusion part 73d of the fixing housing 73, and the other end is sleeved on the retaining portion 708b of the retaining part 708, so that the connector 72 passes through the avoidance slot 701 of the fixed base 711 and the first mounting slot 705 of the floating member 71, and further the connector 72 is mounted inside the floating member 71, and exposed relative to the avoidance slot 701. In this case, the connecting end 722 of the connector 72 is located in the mounting hole 73a, recessed relative to the avoidance slot 701 and exposed relative to the avoidance slot 701, and the mating end protrudes relative to the floating member 71. In this case, the elastic element 709 may bend and deform relative to the avoidance slot 701 and the first mounting slot 705 in the X-Z plane, and may compress and deform along the Y-axis direction, so as to achieve floating of the connector 72 along the X-axis direction, Y-axis direction, and Z-axis direction.

The elastic member 75 is sleeved on the outer side of the extension portion 74b of the connecting member 74, and the extension portion 74b sequentially passes through the first mounting hole of the floating member 71, the second mounting hole 702 of the fixed base 711, and the through hole 212 of the mounting member 210, and is fixed to the inner wall of the second mounting hole 702 and the inner wall of the through hole 212, to achieve assembly of the connector assembly 230 and a fixed connection between the connector assembly 230 and the mounting member 210. In this case, the mounting hole 73a and the avoidance slot 701 are both arranged opposite to the through slot 211, the guide hole 711a of the fixed base 711 is arranged opposite to the positioning hole 213 of the mounting member 210, the connector 72 is exposed relative to the through slot 211, and the elastic member 75 is in a compressed state to press the floating member 71 to the fixed base 711.

In combination with FIG. 12, when the electronic module 200 in the third embodiment and the backplane system 300 in the first embodiment are assembled, the positioning hole 213 of the mounting member 210 in each electronic module 200 and the guide hole 711a of the fixed base 711 align with each group of positioning members 62 of the backplane system 300. The electronic module 200 is pushed along the positive Y-axis direction, so that each group of positioning members 62 aligns with and is sequentially inserted into the positioning hole 213 of the mounting member 210 in the electronic module 200 and the guide hole 711a of the fixed base 711 to guide the through slot 211 of the mounting member 210 to align with the terminal connecting member 310. This facilitates guiding an electrical connection between the connector assembly 230 and the terminal connecting member 310, and in turn, facilitates guiding an electrical connection between the electronic module 200 and the backplane system 300.

In a process of pushing the electronic module 200, the guide hole 73b of the fixing housing 73 in the connector assembly 230 aligns with the guide part 54 of the fixing member 330 in the backplane system 300. The guide part 54 aligns with and is inserted into the guide hole 73b of the fixing housing 73 in the connector assembly 230, guiding the plug-in end portion 310a of the terminal connecting member 310 to sequentially pass through the through slot 211, the avoidance slot 701 and the mounting hole 73a, and extend into and be plugged into the terminal slot 721b of the connector 72. The plurality of first conductive terminals 40 of the first face terminal group and the second face terminal group in the plug-in end portion 310a are electrically connected to the plurality of connecting terminals of two connecting terminal groups mounted in the terminal slot 721b, achieving an electrical connection between the plug-in end portion 310a and the connecting end 722, thereby achieving an electrical connection between the terminal connecting member 310 and the connector assembly 230, and further achieving an electrical connection between the backplane system 300 and the electronic module 200.

When the plug-in end portion 310a of the terminal connecting member 310 is plugged into the terminal slot 721b of the connector 72, the terminal connecting member 310 exerts a thrust along the negative Y-axis direction on the connector 72, and may push the connector 72 along the negative Y-axis direction and compress the elastic element 709. The elastic element 709 may be deformed by compression, allowing the connector 72 to move relative to avoidance slot 701 and the first mounting slot 705 along the negative Y-axis direction. This effectively prevents the plug-in end portion 310a of the terminal connecting member 310 from being over-plugged into the terminal slot 721b of the connector 72, thereby achieving the anti-over-plugging effect. In addition, the elastic element 709 may further deform by bending relative to the avoidance slot 701 and the first mounting slot 705 in the X-Z plane, so that the connector 72 may float along the X-axis, Y-axis, and Z-axis directions, thereby improving accuracy of a plugging connection between the connector 72 and the terminal connecting member 310. The mating gap (Demating) between the connector 72 and the terminal connecting member 310 of the backplane system 300 may be absorbed, which facilitates reducing a signal transmission loss between the electronic module 200 and the backplane system 300.

In addition, when the connector 72 compresses the elastic element 709, thrust along the negative Y-axis direction may be exerted to the floating member 71. The floating member 71 compresses the elastic member 75 under the thrust along the negative Y-axis direction, causing the elastic member 75 to be deformed. This allows the floating member 71 to move relative to the fixed base 711 along the negative Y-axis direction, so that the retaining part 708 of the floating member 71 is movable along the negative Y-axis direction, which in turn drives the connector 72 to move along the negative Y-axis direction. In addition, this increases deformation space of the elastic element 709, and further expands a range to which the connector 72 moves along the negative Y-axis direction, thereby further enhancing the anti-over-plugging effect.

In addition, after being compressed, the elastic member 75 may press the bottom wall of the second mounting slot 707 along the positive Y-axis direction, allowing the floating member 71 to press the fixed base 711 along the positive Y-axis direction. After being compressed, the elastic element 709 may drive the connector 72 to move relative to the through slot 211 along the positive Y-axis direction, ensuring reliable contact between the connecting end 722 of the connector 72 and the plug-in end portion 310a of the terminal connecting member 310. This ensures good electrical contact between the connector 72 and the terminal connecting member 310, thereby ensuring good electrical contact between the backplane system 300 and the electronic module 200.

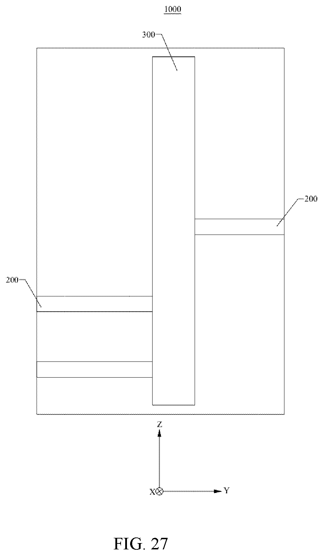

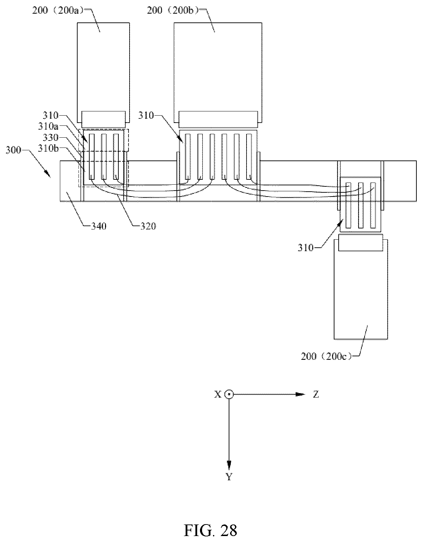

As shown in FIG. 27 and FIG. 28, FIG. 27 is a lateral structural view of the computing device 1000 according to a fourth embodiment of the present application, and FIG. 28 is a cross-sectional structural diagram of an electrical connection structure formed by the plurality of electronic modules 200 and the backplane system 300 in the computing device 1000 shown in FIG. 27. It should be noted that in an electrical connection structure shown in FIG. 28, the plurality of electronic modules 200 are in an unplugged state with the backplane system 300.

The computing device 1000 in the third embodiment differs from the computing device 1000 in the first embodiment in that, in the computing device 1000 in the third embodiment, the plurality of terminal connecting members 310 in the backplane system 300 are located on different sides of the cable box 340, so that the plurality of electronic modules 200 are electrically connected to different sides of the backplane system 300.

Specifically, in the computing device 1000 of the embodiment, the cable box 340 of the backplane system 300 is located in the middle of the cabinet body 100. Some of the plurality of terminal connecting members 310 of the backplane system 300 are mounted on a side of the cable box 340 toward the negative Y-axis direction, and are electrically connected to some of the plurality of electronic modules 200 to mount some of the electronic modules 200 on the side of the cable box 340 toward the negative Y-axis direction. Some of the plurality of terminal connecting members 310 are mounted on the side of the cable box 340 toward the negative Y-axis direction, and are electrically connected to some of the plurality of electronic modules 200, so that some of the electronic modules 200 are mounted on a side of the cable box 340 toward the positive Y-axis direction, thereby achieving the signal interaction among the plurality of electronic modules 200. For example, the computing node 200a and the switching module 200b are located on a side of the backplane system 300 toward the negative Y-axis direction, and a management module 200c is located on a side of the backplane system 300 toward the positive Y-axis direction. The electronic module 200 in the embodiment may be the electronic module 200 in the first embodiment or the second embodiment.

The above disclosure represents merely preferred embodiments of the present application, and should not be construed as a limitation of the scope of the present application. Those skilled in the art can understand and implement all or part of the processes of the above embodiments, and any equivalent changes made based on claims of the present application still fall within the scope covered by the present application.

## Claims

1. A computing device, comprising a connector assembly, a mounting member, an electronic module, and a backplane system; wherein the connector assembly comprises a connecting member, a floating member, and a connector; wherein the mounting member is provided with a through slot, the through slot extends through the mounting member along a thickness direction of the mounting member, the connecting member is fixedly connected to the mounting member, the floating member is movably connected to the connecting member and is movable relative to the connecting member, the connector is fixedly connected to the floating member and is capable of being driven by the floating member to move relative to the mounting member, the connector is electrically connected between the electronic module and the backplane system, the backplane system comprises a terminal connecting member, the terminal connecting member comprises a circuit board and a plurality of first conductive terminals, the plurality of first conductive terminals are mounted at an end portion of the circuit board and spaced apart from each other, each terminal connecting member passes through the through slot and is plugged into the connector, and the plurality of first conductive terminals are electrically connected to the connector.

2. The computing device according to claim 1, further comprising an elastic member, wherein the elastic member is sleeved on the connecting member and abuts against and is connected between the connecting member and the floating member.

3. The computing device according to claim 2, further comprising a fixing housing, wherein the fixing housing is mounted on the floating member and sleeved on an outer side of the connector, the fixing housing is provided with a mounting hole, and an opening of the mounting hole faces the mounting member and exposes a connecting end of the connector.

4. The computing device according to claim 3, wherein a dimension of the mounting hole gradually decreases along a direction facing away from the mounting member toward the connector.

5. The computing device according to any one of claims 2 to 4, wherein the floating member comprises a carrier part and a mounting part fixedly connected to the carrier part, wherein the mounting part is provided with a mounting hole, the mounting hole extends through the mounting part along a length direction of the mounting part, the connecting member passes through the mounting hole, the elastic member is mounted in the mounting hole, and the connector is fixedly connected to the carrier part and spaced apart from the mounting part.

6. The computing device according to claim 5, wherein along a direction from a connector assembly toward the mounting member, the mounting hole comprises a first hole portion and a second hole portion, the first hole portion is located on a side of the second hole portion facing away from the mounting member and in communication with the second hole portion, a hole diameter of the first hole portion is greater than a hole diameter of the second hole portion, the connecting member is in clearance fit with both the first hole portion and the second hole portion, the connecting member passes through the first hole portion and the second hole portion, and the elastic member is mounted in the first hole portion, and abuts against and is mounted between the connecting member and a bottom wall of the first hole portion.

7. The computing device according to claim 6, wherein the carrier part is provided with a guide hole, an opening of the guide hole faces the mounting member, the mounting member is provided with a fixing hole, the fixing hole extends through the mounting member along a thickness direction of the mounting member, and is disposed opposite to the guide hole, the backplane system is provided with a guide member, the guide member is provided on the circuit board and spaced apart from the plurality of first conductive terminals, and the guide member passes through the fixing hole of the mounting member and fixed in the guide hole.

8. The computing device according to claim 6, wherein the connector assembly further comprises a stop member, the stop member is mounted in the first hole portion and abuts against between the elastic member and a bottom wall of the first hole portion, the stop member is provided with a through hole, and the through hole extends through the stop member along a thickness direction of the stop member, and the through hole avoids the connecting member.

9. The computing device according to any one of claims 2 to 4, wherein the floating member is provided with a first mounting hole and a first mounting slot, the first mounting hole and the first mounting slot extend through the floating member along a thickness direction of the floating member, the first mounting hole is spaced apart from the first mounting slot, and the connector is located in the first mounting slot.

10. The computing device according to claim 9, wherein the connector assembly further comprises a fixed base, the fixed base is configured to be fixedly connected to the mounting member and located between the floating member and the mounting member, the fixed base is provided with a second mounting hole and an avoidance slot, the second mounting hole and the avoidance slot extend through the fixed base along a thickness direction of the fixed base, the second mounting hole is spaced apart from the avoidance slot, the connecting member passes through the first mounting hole and the second mounting hole, the avoidance slot is disposed opposite to the first mounting slot, and the connecting end of the connector is exposed relative to the avoidance slot.

11. The computing device according to claim 10, wherein the floating member is provided with a second mounting slot, an opening of the second mounting slot is located in a surface of the floating member facing away from the fixed base, and extends through a circumferential side surface of the floating member, the first mounting hole is provided in a bottom wall of the second mounting slot, and extends through the bottom wall of the second mounting slot along a thickness direction of the bottom wall of the second mounting slot.

12. The computing device according to claim 11, wherein the connector assembly further comprises an elastic element and a plurality of carrier parts, the plurality of carrier parts are spaced apart on a side wall of the avoidance slot and extend toward the avoidance slot, the connector is located in the avoidance slot and abuts against the plurality of carrier parts, and the elastic element abuts against and is connected between the connector and the floating member.

13. The computing device according to claim 11, wherein the connector assembly comprises a plurality of guide posts, the plurality of guide posts are mounted on a surface of the fixed base toward the floating member and extends along a direction toward the floating member, the plurality of guide posts are spaced apart and disposed around the avoidance slot, the floating member is provided with a plurality of fixing holes, the plurality of fixing holes extend through the floating member in a thickness direction of the floating member, the plurality of fixing holes are spaced apart and disposed around the first mounting slot, and each of the guide posts passes through one of the fixing holes.

14. The computing device according to any one of claims 1 to 4, wherein the circuit board comprises a first end portion and a main body portion, the first end portion is electrically connected to an end face of the main body portion and protrudes relative to the main body portion, the first end portion is provided with the plurality of first conductive terminals, the main body portion is provided with a plurality of notches, and openings of the plurality of notches face the first end portion, and are located on opposite sides of the first end portion.

15. A node device, comprising a plurality of electronic components, a connector assembly, and a housing, wherein the plurality of electronic components and the connector assembly are mounted inside the housing, the housing is provided with a through slot, the through slot extends through the housing along a thickness direction of the housing, the connector assembly comprises a connecting member, a floating member, and a connector, the connection member is fixedly connected to the housing, the floating member is movably connected to the connecting member and is movable relative to the connecting member, and the connector is fixedly connected to the floating member and exposed relative to the through slot, and is movable relative to the housing when driven by the floating member.
